# FASCICULE DE BREVET EUROPEEN

(11) **EP 3 627 688 B1**
(45) Date de publication et mention de la délivrance du brevet: **11.05.2022**
(21) Numéro de dépôt: 19197893.1
(22) Date de dépôt: 17.09.2019
(51) Int. Cl.: H02M 7/48, H02M 3/335, H05B 41/282, H02M 1/00

(54) **CONVERTISSEUR DE PUISSANCE**
LEISTUNGSWANDLER
POWER CONVERTER

(30) Priorité: 21.09.2018 FR 1858613
(43) Date de publication de la demande: 25.03.2020
(73) Titulaire: Commissariat à l'Energie Atomique et aux Energies Alternatives, 75015 Paris (FR)
(72) Inventeur: DESPESSE, Ghislain, 38054 GRENOBLE CEDEX 09 (FR); POLLET, Benjamin, 38054 GRENOBLE CEDEX 09 (FR)
(74) Mandataire: Cabinet Beaumont

(56) Documents cités:
- WO-A1-2009/101176
- CN-A- 102 522 492
- CN-B- 101 938 220
- US-A1- 2017 012 556
- ROBERT W ERICKSON ET AL: "Fundamentals of power electronics, Resonant Conversion", 31 December 2001 (2001-12-31), FUNDAMENTALS OF POWER ELECTRONICS, KLUWER ACAD. PUBL, NORWELL, MASS [U.A.], PAGE(S) 705 - 755, XP002625293, ISBN: 978-0-7923-7270-7 * Chapter 19.3 *
- POLLET BENJAMIN ET AL: "Inductor-less DC-DC converter using a piezoelectric transducer", , 1 May 2017 (2017-05-01), XP055857695, Retrieved from the Internet: URL:https://hal.archives-ouvertes.fr/hal-0 1680314/document>

## Description

### Domaine

La présente description concerne de façon générale les systèmes électroniques de conversion d'énergie et, plus particulièrement, la réalisation d'un convertisseur de puissance continu-continu (DC/DC) ou alternatif-continu (AC/DC). La présente description concerne plus précisément un convertisseur à matériau piézoélectrique.

### Exposé de l'art antérieur

Les convertisseurs de puissance des systèmes électroniques peuvent être basés sur différents principes.

Une première catégorie concerne les convertisseurs basés sur l'utilisation de transformateurs. La plupart des transformateurs sont basés sur des enroulements inductifs, mais on trouve également des transformateurs piézoélectriques. Ces derniers transforment une tension alternative en une autre tension alternative avec une amplitude différente et requièrent, comme pour les transformateurs magnétiques, de convertir la tension continue d'entrée en tension alternative puis de redresser la tension alternative fournie par le transformateur.

Une deuxième catégorie concerne les alimentations à découpage qui utilisent un élément inductif de stockage d'énergie et qui découpent une tension continue d'entrée, généralement en modulation de largeur d'impulsions, pour réguler la valeur d'une tension continue de sortie.

Une troisième catégorie concerne les convertisseurs basés sur l'utilisation d'un microsystème électromécanique (MEM). Ces systèmes exploitent une variation de la capacité d'un élément électromécanique pour effectuer une conversion d'énergie de nature électrostatique. Les documents US-B-6,317,342 et US-B-6,058,027 décrivent des exemples de tels convertisseurs.

Une quatrième catégorie, à laquelle s'applique la présente description, concerne les convertisseurs exploitant la résonance d'un matériau piézoélectrique. Par exemple, le document KR-A-20100137913 décrit un convertisseur à transducteur piézoélectrique dans lequel la tension de sortie est régulée en ajustant la fréquence de phases à tension constante et de phases à charge constante, à la manière d'un circuit à capacités commutées.

Le document US-A-2107/012556 décrit un convertisseur de puissance DC-AC à transformateur piézoélectrique.

Le document CN-B-101938220 décrit un convertisseur d'énergie piézoélectrique haute puissance.

Le document CN-A-1 02522492 décrit un convertisseur d'énergie AC-DC à transformateur piézoélectrique.

Le document WO 2009/101176 décrit un convertisseur de puissance résonnant comprenant un transformateur piézoélectrique adapté.

Le document "Fundamentals of power electronics, Resonant Conversion" de Robert W Erickson et al., 31 décembre 2001 (2001-12-31), Fundamentals of Power Electronics, KLUWER ACAD. PUBL, Norwell, Mass [U.A.], pages 705-755, XP002625293, décrit des principes de conversion résonante. Le document "Inductorless DC-DC converter using a piezoelectric transducer" de Benjamin Pollet et al. se réfère à un convertisseur resonant avec un élément piézoélectrique.

### Résumé

Un mode de réalisation pallie tout ou partie des inconvénients des convertisseurs de puissance.

Un mode de réalisation propose une solution tirant profit des avantages des matériaux piézoélectriques.

Un mode de réalisation propose une solution permettant de réguler la tension de sortie du convertisseur en fonction des besoins de la charge.

Un mode de réalisation propose une architecture de convertisseur compatible avec une utilisation en convertisseur DC/DC, AC/DC, abaisseur de tension (buck), élévateur de tension (boost) ou abaisseur-élévateur (buck-boost).

Un mode de réalisation propose une architecture de convertisseur compatible avec la fourniture de plusieurs tensions de sortie.

Ainsi, un mode de réalisation prévoit un convertisseur de puissance comportant les caractéristiques de la revendication indépendante.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une représentation schématique et sous forme de blocs d'un système utilisant un convertisseur du type auquel s'appliquent les modes de réalisation décrits ;
la figure 2 représente, de façon très schématique et sous forme de blocs, trois modes de réalisation de convertisseurs (vues (a), (b) et (c));
la figure 3 représente, de façon schématique et générale, un mode de réalisation d'une architecture de convertisseur continu-continu ;
la figure 4 illustre, par des chronogrammes schématiques, un exemple de fonctionnement du convertisseur de la figure 3 en élévateur de tension ;
la figure 5 illustre, par des chronogrammes, un autre exemple de fonctionnement du convertisseur de la figure 3 en élévateur de tension ;
la figure 6 représente, de façon schématique, un mode de réalisation du circuit de la figure 3, dédié à un fonctionnement en abaisseur de tension ;
la figure 7 illustre, par des chronogrammes schématiques, un exemple de fonctionnement du convertisseur de la figure 6 en abaisseur de tension ;
la figure 8 illustre, par des chronogrammes schématiques, un autre mode de réalisation d'un convertisseur abaisseur, basé sur le montage de la figure 3 ;
la figure 9 illustre, par des chronogrammes schématiques, un mode de réalisation d'un convertisseur inverseur d'une tension négative en une tension positive, basé sur le montage de la figure 3 ;
la figure 10 représente, de façon schématique, un mode de réalisation d'un convertisseur alternatif-continu respectant l'architecture de la figure 3 ;
la figure 11 illustre, par des chronogrammes, un exemple pratique de fonctionnement du convertisseur de la figure 10 ;
La figure 12 représente un autre mode de réalisation d'un convertisseur alternatif-continu respectant l'architecture de la figure 3 ;
la figure 13 illustre, par des chronogrammes, un mode de commande des interrupteurs du convertisseur de la figure 12 lorsque la tension d'entrée est négative ;
la figure 14 illustre, par un chronogramme, un exemple pratique de fonctionnement du convertisseur de la figure 12 ;
la figure 15 représente un autre mode de réalisation d'un convertisseur alternatif-continu ;
la figure 16 illustre, par des chronogrammes, le fonctionnement du convertisseur de la figure 15 ;
la figure 17 représente le schéma d'un mode de réalisation permettant de fournir plusieurs tensions de sortie ;
la figure 18 illustre, par des chronogrammes, un mode de commande du convertisseur de la figure 17 pour obtenir un fonctionnement en convertisseur abaisseur continu-continu ;
la figure 19 représente, de façon très schématique, un autre mode de réalisation d'une architecture de convertisseur ; et
la figure 20 représente, de façon très schématique, encore un autre mode de réalisation d'une architecture de convertisseur.

### Description détaillée

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la constitution et réalisation des circuits en amont et en aval des convertisseurs décrits n'a pas été détaillée, les modes de réalisation décrits étant compatibles avec les applications usuelles de tels convertisseurs.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

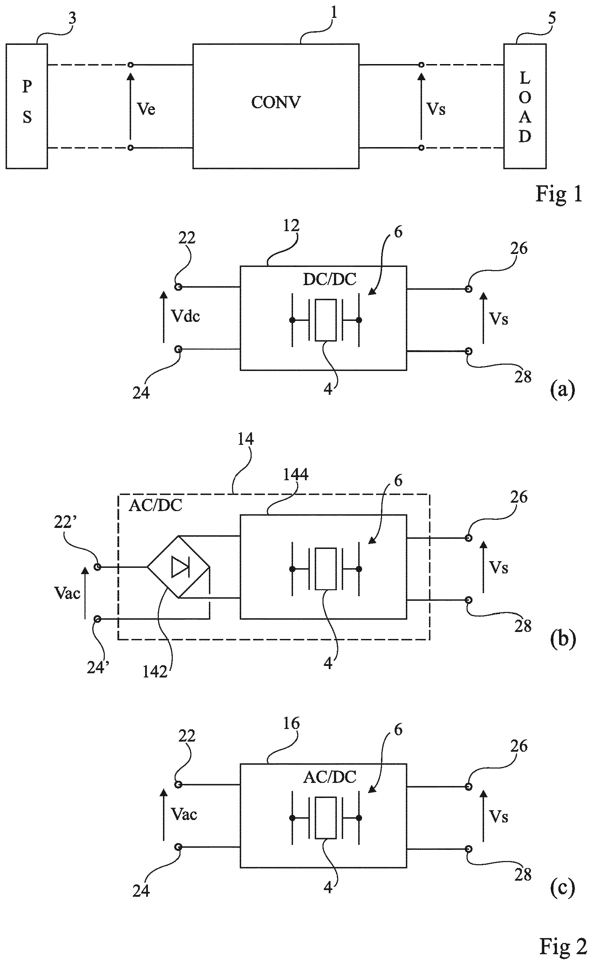

La figure 1 est une représentation schématique et sous forme de blocs d'un système utilisant un convertisseur du type auquel s'appliquent les modes de réalisation décrits.

Un convertisseur 1 (CONV) a pour rôle de convertir une première tension ou tension d'entrée Ve, fournie par exemple par une source d'énergie 3 (PS), en une deuxième tension ou tension de sortie Vs, destinée à alimenter une charge ou une batterie 5 (LOAD). Le plus souvent le convertisseur 1 régule également la tension Vs fournie à la charge. Le convertisseur 1 peut, de façon générale, convertir une tension continue en une tension continue (DC/DC) ou alternative (DC/AC), ou une tension alternative en une tension continue (AC/DC) ou alternative (AC/AC). Selon les applications, cette conversion s'effectue en un ou plusieurs étages successifs. La source d'énergie 3 (PS) est, par exemple, une batterie, un panneau solaire, le réseau électrique alternatif, etc. Le convertisseur 1 peut, selon les applications, élever ou abaisser la tension Ve fournie par la source d'énergie 3.

Dans un convertisseur 1 de type alimentation à découpage basé sur un élément inductif de stockage d'énergie, la commande du convertisseur est généralement effectuée en modulation de largeur d'impulsions afin de contrôler les périodes d'accumulation d'énergie dans l'élément inductif et de restitution de cette énergie à la charge. Une telle commande n'est cependant pas transposable à un convertisseur basé sur un élément en matériau piézoélectrique. En effet, il faut d'une part que la commande soit à la fréquence de résonance du piézoélectrique et d'autre part que la commande soit synchronisée par rapport au courant interne du piézoélectrique (lié à la déformation du piézoélectrique). En effet, lors de la connexion de la source, il faut que le courant interne du piézoélectrique soit d'un certain signe pour que le produit tension d'entrée par le courant d'entrée conduise à un apport d'énergie au piézoélectrique. Inversement, le courant interne du piézoélectrique doit être d'un certain signe pour que le produit tension de sortie par courant de sortie conduise à une réduction d'énergie au niveau du piézoélectrique au profit de la sortie. Or, le courant interne est sensiblement sinusoïdal et à la fréquence de résonance du piézoélectrique. De manière générale, un piézoélectrique a un comportement capacitif (l'application d'une tension DC ne conduit pas à l'apparition d'un courant) alors qu'une inductance soumise à une tension DC conduit à une croissance théoriquement indéfinie de son courant. Cette différence rend les lois de commande des convertisseurs inductifs non adaptées au pilotage de convertisseurs piézoélectriques.

Il serait néanmoins souhaitable de tirer profit des principes de découpage de la tension d'entrée et d'accumulation d'énergie et de les utiliser avec un matériau piézoélectrique afin de tirer profit des avantages des matériaux piézoélectriques, notamment en termes de faibles pertes et de faible encombrement.

La solution décrite par le document KR-A-20100137913 n'est également pas transposable dans la mesure où cette solution prévoit de réguler la tension de sortie en ajustant la fréquence de commutation, ce qui conduit à s'éloigner de la fréquence de résonance du matériau piézoélectrique, et engendre une diminution du facteur de qualité et du rendement. Or, un matériau piézoélectrique est précisément préféré à une inductance afin de tirer profit d'un meilleur facteur de qualité. Par conséquent, cette solution est en pratique limitée à des applications dans lesquelles la puissance de la charge varie peu et à un facteur deux entre la tension d'entrée et la tension de sortie, sauf à multiplier le nombre de transducteurs piézoélectriques, ce qui nuit alors au faible encombrement qui, là encore, est l'un des avantages d'un matériau piézoélectrique par rapport à un matériau magnétique.

Les solutions basées sur une variation de la capacité d'un élément électromécanique (tel que décrit dans l'article « Microresonant devices for power conversion » J. Mark Noworolski et Seth R. Sanders, Proceedings Volume 3514, Micromachined Devices and Components IV; 1998) pour effectuer une conversion d'énergie de nature électrostatique ne sont également pas transposables aux éléments piézoélectriques. En effet, dans le cas électrostatique, si aucune charge n'est stockée sur la structure à capacité variable, aucune tension n'est délivrée même si une variation de capacité à lieu. Il faut donc polariser la structure électrostatique et, dans le cas où cette charge de polarisation est retirée, il faut en remettre une, ce qui introduit des pertes (en particulier une commutation à zéro de tension n'est pas possible). Par ailleurs, le mouvement mécanique et donc la variation de capacité ne peut pas conduire à une inversion de signe de la charge stockée ou de la tension stockée, ce qui écarte toute possibilité d'utiliser des tensions de signe opposé au cours du cycle. En outre, tous les cycles décrits dans la présente description ne fonctionnent pas avec une structure électrostatique, car la tension aux bornes de l'élément piézoélectrique passe toujours par 0 et va parfois même en tension négative.

Les modes de réalisation décrits tirent leur origine d'une analyse du fonctionnement d'un matériau piézoélectrique à la résonance pour exploiter des phases de transfert de charges permettant non seulement de s'affranchir de l'utilisation d'un élément inductif, mais également de réguler la tension de sortie en conservant la résonance du matériau piézoélectrique, c'est-à-dire avec des cycles de commutation répétés à une fréquence qui correspond à la fréquence de résonance du piézoélectrique, dont on ajuste les durées des phases de commutation respectives à l'intérieur du cycle.

Plus particulièrement, l'oscillation mécanique d'un élément piézoélectrique est approximativement sinusoïdale. Une augmentation ou une diminution de l'énergie stockée sur une période conduit respectivement à une augmentation ou à une diminution de l'amplitude d'oscillation. Par ailleurs, en circuit ouvert (à charge constante), une augmentation de l'amplitude des oscillations engendre une augmentation de l'amplitude de la tension à vide aux bornes de l'élément piézoélectrique, alors que, à tension constante, cette augmentation d'amplitude d'oscillation conduit à une augmentation du courant.

Selon les modes de réalisation décrits, on prévoit d'alterner des phases à tension sensiblement constante et à charge sensiblement constante aux bornes de l'élément piézoélectrique, à l'intérieur de périodes de durée sensiblement constante correspondant à la fréquence de résonance ou fréquence propre de l'élément piézoélectrique.

Les modes de réalisation décrits sont basés sur une architecture particulière de convertisseur dans laquelle un élément piézoélectrique est placé dans la branche d'un pont d'interrupteurs.

Une différence par rapport à des convertisseurs de type transformateur tels que décrits dans les documents US-A-2107/012556, CN-B-101938220 et CN-A-102522492, dans lesquels des bornes d'un élément piézoélectrique se trouvent côté entrée tandis que d'autres bornes se trouvent côté sortie, les deux bornes de l'élément piézoélectrique du convertisseur décrit peuvent se retrouver reliées à l'entrée ou à la sortie du convertisseur en fonction des phases de commutation. Plus particulièrement, dans les documents cités, en pratique, le transformateur piézoélectrique compte quatre électrodes, deux qui servent à l'apport d'énergie au matériau piézoélectrique depuis l'entrée et deux qui servent à la restitution d'énergie à la sortie. Dans certaines phases de fonctionnement, l'entrée et la sortie peuvent être connectées en même temps au piézoélectrique. Dans les modes de réalisation décrits, il n'y a pas d'électrodes séparées entre l'entrée et la sortie (il n'y a pas d'électrodes dédiées à l'entrée et d'électrodes différentes dédiées à la sortie). Il n'y a donc pas de phase dans laquelle l'entrée et la sortie peuvent être connectées en même temps à l'entrée et à la sortie (cela provoquerait un court-circuit entre l'entrée et la sortie).

La figure 2 représente, de façon très schématique et sous forme de blocs, trois modes de réalisation de convertisseurs (vues (a), (b) et (c)).

Tous ces modes de réalisation sont basés sur l'utilisation d'au moins un élément piézoélectrique 4 monté dans une branche (dans la barre horizontale dans l'orientation des figures) d'un pont 6 d'interrupteurs (non représentés en figure 2) en H.

La vue (a) de la figure 2 représente le cas d'un convertisseur 12 continu-continu (DC/DC) convertissant une tension continue d'entrée Vdc, appliquée entre deux bornes 22 et 24 d'entrée du convertisseur 12, en une tension continue de sortie Vs, fournie entre deux bornes 26 et 28 de sortie du convertisseur 12.

La vue (b) de la figure 2 représente le cas d'un convertisseur 14 alternatif-continu (AC/DC) convertissant une tension alternative d'entrée Vac, appliquée entre deux bornes 22' et 24' d'entrée du convertisseur 14, en une tension continue de sortie Vs, fournie entre deux bornes 26 et 28 de sortie du convertisseur 14. Dans l'exemple de la vue (b), on suppose que le convertisseur 14 comporte un étage 142 de redressement (typiquement un pont redresseur) de la tension alternative Vac, associé à un étage 144 de conversion continue-continue. L'étage de conversion continue-continue 144 est typiquement un convertisseur du type du convertisseur 12 de la vue (a) de la figure 2.

La vue (c) de la figure 2 représente un autre mode de réalisation d'un convertisseur 16 alternatif-continu (AC/DC) convertissant une tension alternative d'entrée Vac, appliquée entre deux bornes 22 et 24 d'entrée du convertisseur 16, en une tension continue de sortie Vs, fournie entre deux bornes 26 et 28 de sortie du convertisseur 16. Dans le mode de réalisation de la figure 2(c), les interrupteurs du convertisseur en pont participent directement au redressement de la tension alternative d'entrée.

Selon les modes de réalisation décrits, on prévoit une commutation particulière des interrupteurs du convertisseur pour qu'au cours de chaque période de résonance du matériau piézoélectrique de l'élément 4 on alterne des phases à tension sensiblement constante et des phases à charge sensiblement constante. Les phases à tension sensiblement constante permettent, en régime établi ou permanent, de passer d'une tension constante à une autre et de fermer les interrupteurs qui doivent l'être lorsque la tension à leurs bornes est sensiblement nulle, de préférence nulle (commutation dite au zéro de tension).

De telles phases de commutation permettent, au cours d'un cycle d'oscillation mécanique du matériau piézoélectrique, à la fois d'injecter et de retirer la même quantité d'énergie, sans assister à une saturation de l'amplitude des oscillations (trop d'énergie apportée) ou à un amortissement de ces oscillations (trop d'énergie consommée). Dans le premier cas, on détériorerait le facteur de qualité et le rendement. Dans le second cas, le système finirait par ne plus fonctionner.

Par ailleurs, on prévoit une commande particulière des différents interrupteurs afin de respecter, en régime établi, que sur un cycle de déformation du matériau piézoélectrique, c'est-à-dire sur une période d'oscillation à la résonance et vu de l'élément piézoélectrique, la somme des charges échangées avec l'extérieur est nulle et la somme des énergies échangées avec l'extérieur est nulle (aux pertes près).

Plus particulièrement, on prévoit que la fermeture de chaque interrupteur s'effectue sous une tension approximativement nulle à ses bornes. Cela participe à obtenir un équilibre d'énergie du point de vue de l'élément piézoélectrique sur une période de résonance. De plus, la commande des interrupteurs est de préférence synchronisée par rapport au courant interne à l'élément piézoélectrique. Cette synchronisation s'effectue, pour chaque période de résonance, par détection d'un passage par zéro du courant interne de l'élément piézoélectrique. Cette synchronisation permet notamment de s'assurer que, durant la phase d'apport d'énergie, le courant soit du bon signe et toujours du même signe pour apporter de l'énergie au piézoélectrique et de signe opposé lors de la redistribution d'énergie à la sortie. Par ailleurs, la synchronisation permet d'une part de maximiser la puissance échangée pour une amplitude de courant interne au piézoélectrique donnée et d'autre part de s'assurer que, durant les phases à charge constante, la tension va bien varier dans le bon sens pour atteindre le palier de tension suivant et ainsi permettre de fermer l'interrupteur suivant avec une tension nulle à ses bornes. On notera que les phases à charges constantes ne sont pas de simples phases de temps mort évitant un risque de court-circuit en laissant le temps à un premier transistor de s'ouvrir avant d'en fermer un autre, mais bien des phases où la tension du piézoélectrique évolue d'elle-même du palier de tension précédent au palier de tension suivant et ce sans l'utilisation de circuits d'aide à la commutation par exemple constitués de composants passifs supplémentaires (inductances/capacités).

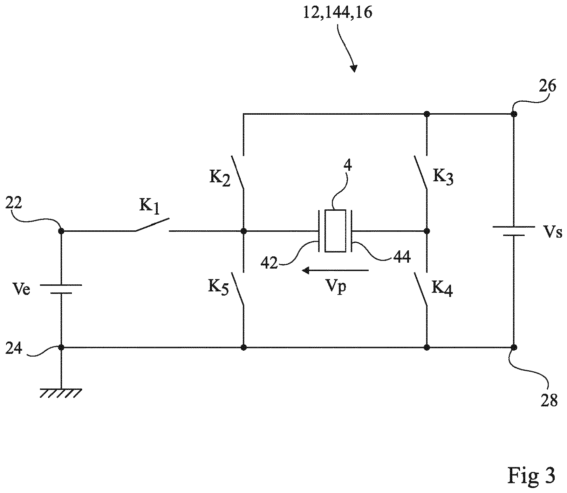

La figure 3 représente, de façon schématique et générale, un mode de réalisation d'une architecture de convertisseur continu-continu, que respectent les convertisseurs 12, 144 et 16 de la figure 2.

L'architecture de la figure 3 est compatible, en fonction des signaux de commande appliqués aux interrupteurs, avec une utilisation en élévateur, en abaisseur, en abaisseur-élévateur, voire en inverseur de tension.

Le convertisseur de la figure 3 comporte :
un élément piézoélectrique 4 ;
un premier interrupteur K1 reliant, de préférence connectant, une première électrode 42 de l'élément piézoélectrique à une première borne 22 d'application d'une tension d'entrée Ve à convertir ;
un deuxième interrupteur K2 reliant, de préférence connectant, l'électrode 42 à une première borne 26 de fourniture d'une tension de sortie Vs ;
un troisième interrupteur K3 reliant, de préférence connectant, une deuxième électrode 44 de l'élément piézoélectrique 4 à la première borne 26 de fourniture de la tension Vs ;
un quatrième interrupteur K4 reliant, de préférence connectant, l'électrode 44 à une deuxième borne 28 de fourniture de la tension Vs ; et
un cinquième interrupteur K5 reliant, de préférence connectant, l'électrode 42 à une deuxième borne 24 d'application de la tension Ve.

La connexion des interrupteurs K2, K3, K4 et K5 définissent, avec l'élément 4, un pont (schématisé sous la forme d'un pont en H) avec les extrémités des branches du pont interconnectées. Ce montage peut aussi définir schématiquement un pont en losange avec un interrupteur dans chaque côté et l'élément piézoélectrique 4 dans une diagonale du losange.

Selon les modes de réalisation et les applications, les interrupteurs peuvent être des transistors MOSFETs (Metal Oxide Semiconductor Field Effect Transistor), des transistors bipolaires, des transistors IGBT (Insulated Gate Bipolar Transistor), des diodes, des transistors à base de silicium, de GaN (Gallium Nitride), de SiC (carbure de silicium) ou de diamant, des relais, des micro-commutateurs, des thyristors, etc. ou une combinaison d'interrupteurs de différentes natures.

Le rôle de l'interrupteur K1 est de contrôler les phases où de l'énergie est transférée de la source d'énergie (tension Ve) vers l'élément piézoélectrique 4. L'interrupteur K1 permet également d'isoler l'élément piézoélectrique de la tension d'entrée. C'est notamment ce qui permet de pouvoir relier, dans certaines phases de commutation, les deux bornes de l'élément piézoélectrique à la sortie.

Le rôle des interrupteurs K3 et K4 est de contrôler les phases où de l'énergie est transférée de l'élément piézoélectrique à la charge (non représentée en figure 3) .

Dans le mode de réalisation de la figure 3, les bornes 24 et 28 sont confondues et définissent la référence des tensions Ve et Vs.

Avec une structure telle que représentée en figure 3, la fonction (élévateur, abaisseur, inverseur) dépend de la commande appliquée aux interrupteurs.

Selon un mode de réalisation, tous les interrupteurs sont bidirectionnels en tension et le montage peut alors assurer toutes les fonctions.

Selon un autre mode de réalisation, dans lequel le convertisseur est dédié à une fonction, certains interrupteurs n'ont pas besoin d'être bidirectionnels en tension, voire peuvent être remplacés par des diodes (ou autres interrupteurs à commande intrinsèque/automatique en fonction de la tension à leurs bornes) .

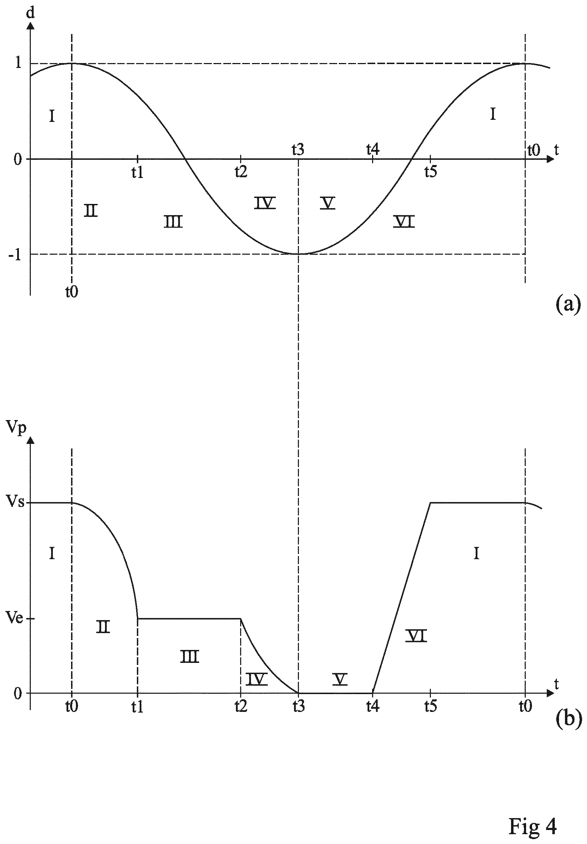

La figure 4 illustre, par des chronogrammes schématiques, un exemple de fonctionnement du convertisseur de la figure 3 en élévateur de tension.

Cette figure illustre le fonctionnement en régime établi ou permanent, c'est-à-dire à partir du moment où l'on a atteint la résonance du matériau piézoélectrique avec une amplitude sensiblement constante, c'est-à-dire avec des échanges d'énergie et de charges sensiblement équilibrés sur chaque période. Il y a donc une identité (au moins approximative) de la fréquence des cycles de commande avec la fréquence de résonance de l'élément piézoélectrique 4. Ainsi, le convertisseur fonctionne à la fréquence de résonance de l'élément piézoélectrique. Pour simplifier la description, on néglige les pertes dans les interrupteurs à l'état passant ainsi que les pertes dans le matériau piézoélectrique à la résonance.

La vue (a) de la figure 4 illustre la déformation mécanique d de l'élément piézoélectrique 4 au cours d'un cycle (une période) de résonance. L'échelle de déformation est normalisée.

La vue (b) de la figure 4 illustre un exemple correspondant d'allure de la tension Vp (figure 3) aux bornes de l'élément piézoélectrique 4.

En régime permanent, on alterne des phases pendant lesquelles tous les interrupteurs sont ouverts et des phases pendant lesquelles au moins deux des interrupteurs sont fermés.

La tension Vp aux bornes de l'élément piézoélectrique 4 a trois phases I, III et V pendant lesquelles cette tension est stable et vaut respectivement, dans l'exemple de la figure 4, Vs, Ve et 0, et trois phases II, IV et VI de transition entre ces états stables.

Le fonctionnement décrit ci-dessous est périodique, de préférence à la fréquence de résonance de l'élément piézoélectrique.

On suppose qu'initialement (phase I), les interrupteurs K2 et K4 sont fermés et tous les autres interrupteurs K1, K3 et K5 sont ouverts. La tension Vp est alors égale à la tension Vs.

A un instant t0, où l'élément 4 est à son amplitude de déformation d maximale (1) dans une direction (arbitrairement positive), correspondant à un instant où le courant dans l'élément piézoélectrique 4 est nul, on ouvre tous les interrupteurs (en fait les interrupteurs K2 et K4 car les autres sont déjà ouverts) . La déformation de l'élément 4 diminue alors et, avec celle-ci, la tension Vp à ses bornes. On est dans une phase (II) où l'on fonctionne à charge constante dans l'élément piézoélectrique 4.

Quand (instant t1) la tension Vp en diminuant atteint la valeur Ve de la tension d'entrée, les interrupteurs K1 et K4 sont fermés et les autres interrupteurs restent ouverts. On assiste alors (phase III) à un transfert d'énergie de la source d'énergie vers l'élément 4. La tension Vp aux bornes de l'élément 4 est égale à la tension d'entrée Ve. Ce transfert d'énergie se poursuit jusqu'à un instant t2 où tous les interrupteurs sont de nouveau ouverts (en pratique les interrupteurs K1 et K4 dans la mesure où les autres interrupteurs le sont déjà).

On passe alors (à l'instant t2) dans une phase IV où tous les interrupteurs sont ouverts. Cette phase à charge constante se poursuit jusqu'à un instant t3 où l'élément 4 atteint sa déformation maximale d dans l'autre direction (-1) par rapport à la direction dans laquelle il a atteint la déformation (1). La dérivée de la tension aux bornes de l'élément 4 est nulle à l'instant t3.

A cet instant t3 où, dans l'exemple de la figure 4, la tension Vp est égale ou proche de 0 et, plus généralement, correspond à sa valeur minimale (passage de la dérivée de la tension par zéro), on ferme les interrupteurs K2 et K3 (en variante, les interrupteurs K4 et K5 ou tous les interrupteurs du pont 6) et on assiste à un transfert de charges entre les électrodes de l'élément piézoélectrique 4. Cette phase V qui, dans l'exemple des figures 3 et 4 s'effectue sous tension nulle, permet de préserver à la fois l'équilibre des charges et des énergies du point de vue de l'élément piézoélectrique 4 au cours d'un cycle.

A un instant t4, on provoque l'ouverture des interrupteurs K2 et K3 (en variante, des interrupteurs K4 et K5 ou de tous les interrupteurs du pont 6). On est de nouveau dans une phase VI où tous les interrupteurs sont ouverts. L'oscillation de l'élément 4 se poursuit à vide jusqu'à un instant t5 où la tension à ses bornes atteint de nouveau la valeur de la tension de sortie Vs.

A cet instant t5, les interrupteurs K2 et K4 sont fermés et l'énergie est transférée à la charge. Ce transfert (phase I) se poursuit jusqu'à ce que le courant dans le matériau piézoélectrique 4 s'annule (instant t0) et que l'on retrouve la phase II où l'on ouvre tous les interrupteurs.

Les signaux de commande des différents interrupteurs sont générés en fonction des niveaux de tension et des besoins de la charge. La régulation est effectuée en réglant les instants d'apparition des différentes phases dans un cycle. Les différentes phases, donc également les cycles, sont synchronisées, par rapport au courant interne dans l'élément piézoélectrique, par la détection (instant t0) de l'annulation du courant interne dans l'élément piézoélectrique.

La détection de l'instant t1 s'effectue, par exemple, par une mesure de la tension Vp de façon à fermer les interrupteurs K1 et K4 quand cette tension atteint la valeur Ve. Selon un autre mode de réalisation, où la puissance ou le courant prélevé par la charge est mesuré ou connu, l'instant t1 est déterminé par temporisation (par exemple à partir de l'ouverture de l'interrupteur K2 et des durées de temporisation précalculées en fonction du courant de sortie).

La détermination de l'instant t2 s'effectue par exemple par temporisation dans un fonctionnement où la puissance/le courant de sortie est mesuré ou connu. Selon un autre exemple de réalisation, on détermine cet instant par rapport au cycle précédent en l'avançant ou en le retardant selon qu'au cycle précédent la tension Vp était nulle ou non à l'instant t3 où la dérivée de la tension Vp est nulle. On pourra par exemple utiliser une régulation de type proportionnelle-intégrale.

La détermination de l'instant t3 peut être effectuée par temporisation (par exemple en utilisant un compteur temporel ou timer). En effet, l'instant t3 correspond à la demi-période à partir de l'instant t0. On peut également détecter l'inversion de négatif à positif de la dérivée de la tension Vp, ou encore utiliser un capteur d'extrema de déformation du matériau piézoélectrique.

L'instant t4, donc la durée de la phase V, conditionne la quantité de charges qui sera retirée du piézoélectrique à tension nulle, c'est-à-dire sans retrait d'énergie du piézoélectrique. Plus cette phase V est longue, moins on retire d'énergie du piézoélectrique et plus on favorise un cycle avec un bilan d'énergie positif. Plus le bilan d'énergie est positif, plus l'amplitude de déformation du piézoélectrique augmente d'un cycle à l'autre et plus la puissance/le courant de sortie finira par être élevé. En effet, durant la phase I, plus le courant est élevé, plus la quantité de charges transmises à la sortie est élevée, d'autant plus que la durée de la phase I augmente en même temps que l'on augmente la durée de la phase V (l'augmentation de l'amplitude de la déformation accélère la variation de tension durant la phase VI et raccourcit donc la durée de la phase VI, ce qui au final laisse plus de durée disponible à la fois pour la phase V et pour la phase I). La détermination de l'instant t4 s'effectue de préférence en mesurant la tension de sortie Vs et en la comparant à une valeur de référence/de consigne. On pourra également effectuer le même type d'asservissement de l'instant t4 en régulant la puissance de sortie ou le courant de sortie.

Les instants t5 et t0 sont par exemple automatiques dans le cas de l'utilisation d'une diode en guise d'interrupteur K2. En variante, pour l'instant t5, on peut mesurer la tension aux bornes de l'élément 4 pour détecter quand elle atteint la valeur Vs, ou utiliser un compteur temporel. Pour l'instant t0, on peut détecter une inversion du sens du courant, un extremum de déformation du matériau piézoélectrique, un compteur temporel, etc.

Une autre différence entre les modes de réalisation décrits et les documents antérieurs susmentionnés qui fonctionnent en transformateur est que le transfert d'énergie s'effectue sur la base d'une différence de tension Ve-Vs entre deux tensions continues. L'élément piézoélectrique n'est, dans les modes de réalisation décrits, pas attaqué par une tension alternative.

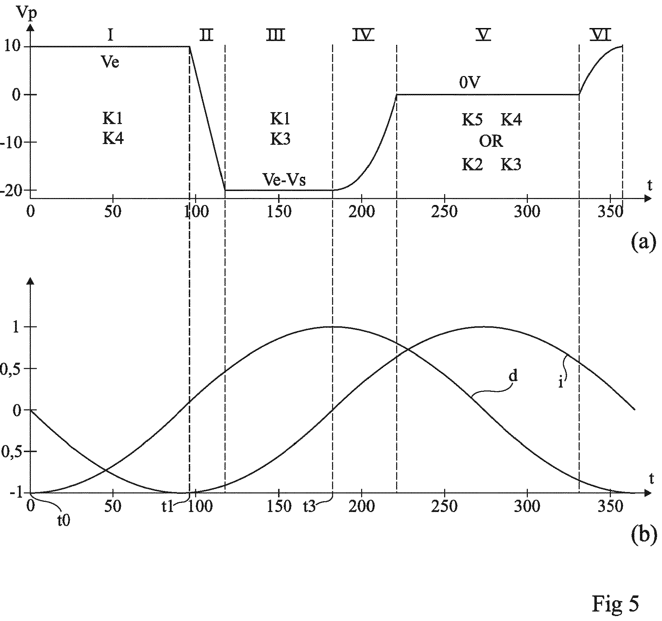

La figure 5 illustre, par des chronogrammes, un autre exemple de fonctionnement du convertisseur de la figure 3 en élévateur de tension.

Plus précisément, la figure 5 illustre, par des chronogrammes, un autre mode de commande des interrupteurs K1 à K5 de la figure 3 pour obtenir un fonctionnement en élévateur de tension.

La vue (a) de la figure 5 illustre un exemple d'allure de la tension Vp aux bornes de l'élément piézoélectrique 4 au cours d'un cycle (une période) de résonance. Les échelles de tension Vp et de temps t sont arbitraires. On suppose dans cet exemple une tension Ve de 10 volts et une tension Vs souhaitée de 30 volts.

La vue (b) de la figure 5 illustre la déformation mécanique d de l'élément piézoélectrique 4 et la valeur du courant i dans l'élément piézoélectrique 4 s'il est était maintenu à tension constante. En pratique, seules des portions de ce courant sont échangées avec l'extérieur, portions correspondant aux phases à tension constante. Le reste du temps, ce courant charge/décharge la capacité parallèle du modèle équivalent électrique du piézoélectrique. Nous appellerons ce courant i, le courant motionnel du piézoélectrique par la suite. Les échelles de déformation d et de courant i sont normalisées.

On retrouve les six phases I, II, III, IV, V et VI de fonctionnement illustrées en relation avec la figure 4. Toutefois, les paliers de tension sont ici à Ve, Ve-Vs et 0.

Comme pour le mode de réalisation illustré en figure 4, tous les interrupteurs sont ouverts dans les phases II, IV et VI où la tension Vp aux bornes de l'élément piézoélectrique 4 varie. De même, la phase V correspond au cas où la tension Vp est nulle et où les interrupteurs K2 et K3 (en variante les interrupteurs K4 et K5 ou tous les interrupteurs du pont 6) sont fermés tandis que les autres interrupteurs sont ouverts. Toutefois, la phase I dans laquelle les interrupteurs K1 et K4 sont fermés correspond à un état dans lequel la tension Vp est égale la tension d'entrée Ve. De plus, la phase III correspond à une phase dans laquelle les interrupteurs K1 et K3 sont fermés (tous les autres interrupteurs étant ouverts) et où la tension Vp vaut Ve-Vs, c'est-à-dire une tension négative car la tension Vs est supérieure à la tension Ve (mode élévateur).

Dans le cycle illustré en figure 5, le maximum (1) de déformation d est à l'instant t3 de commutation de la phase III à la phase IV et le minimum (-1) de déformation d est à l'instant t0 de commutation de la phase VI à la phase I.

Le courant motionnel i du piézoélectrique a une allure sinusoïdale de même période que la déformation d.

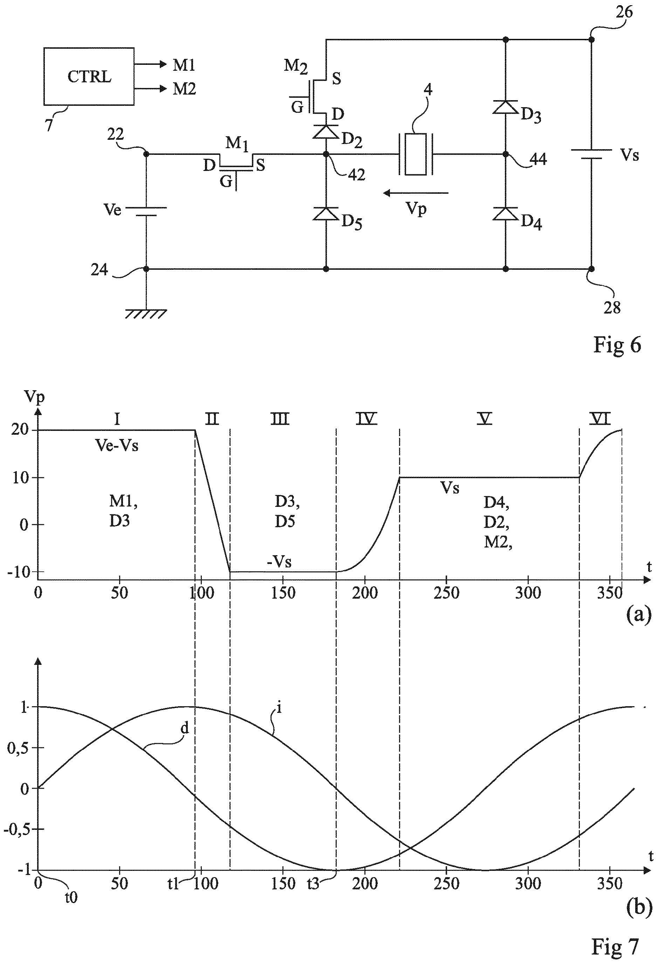

La figure 6 représente, de façon schématique, un mode de réalisation du circuit de la figure 3, dédié à un fonctionnement en abaisseur de tension.

Selon ce mode de réalisation :
l'interrupteur K1 est constitué d'un transistor MOS M1 dont le drain D est relié, de préférence connecté, à la borne 22, dont la source S est reliée, de préférence connectée, à l'électrode 42 de l'élément 4 et dont la grille G reçoit un signal de commande (en tout ou rien) d'un circuit 7 (CTRL) de génération de signaux de commande ;
l'interrupteur K2 est constitué d'un transistor MOS M2, en série avec une diode D2, la source S du transistor M2 étant côté borne 26, sa grille G recevant un signal de commande du circuit 7, et l'anode de la diode D2 étant côté électrode 42 ; et
les interrupteurs K3, K4 et K5 sont respectivement constitués de diodes D3, D4 et D5, les anodes des diodes D4 et D5 étant reliées, de préférence connectées aux bornes communes 24 et 28 et la cathode de la diode D3 étant reliée, de préférence connectée, à la borne 26.

Le rôle de la diode D2 est d'assurer un blocage automatique selon la différence de potentiel entre les bornes 26 et 42 et d'assurer ainsi la bidirectionnalité en tension de l'interrupteur K2 alors que le transistor M2 ne l'est pas à lui seul.

On notera qu'un circuit 7 de commande fournissant des signaux de commande en tout ou rien aux différents interrupteurs commandables est présent dans tous les modes de réalisation. Ce circuit fournit les signaux de commande, de préférence, en fonction d'informations côté charge et/ou côté source d'énergie pour assurer la fourniture d'une tension Vs régulée à une valeur souhaitée. Le circuit 7 ne fournit pas nécessairement de signal de commande à chaque interrupteur. En particulier, certains interrupteurs peuvent, selon les modes de réalisation, être des diodes ou similaires.

La figure 7 illustre, par des chronogrammes schématiques, un exemple de fonctionnement du convertisseur de la figure 6 en abaisseur de tension.

La vue (a) de la figure 7 illustre un exemple d'allure de la tension Vp aux bornes de l'élément piézoélectrique 4 au cours d'un cycle (une période) de résonance. Les échelles de tension Vp et de temps t sont arbitraires. Dans l'exemple de la figure 7, on suppose une tension d'entrée Ve de 30 volts et une tension de sortie Vs souhaitée de 10 volts.

La vue (b) de la figure 7 illustre la déformation mécanique d de l'élément piézoélectrique 4 et la valeur du courant motionnel i dans l'élément piézoélectrique 4. Les échelles de déformation d et de courant motionnel i sont normalisées sur une période d'oscillation de l'élément piézoélectrique.

Le mode de réalisation en abaisseur illustré par les figures 6 et 7 requiert que la tension d'entrée Ve soit au moins deux fois supérieure à la tension de sortie Vs souhaitée.

La séquence de commutation comporte là encore six phases, dont trois phases (II, IV et VI) dans lesquelles la tension Vp n'est pas stable, les interrupteurs M1 et M2 étant ouverts et les diodes D2, D3, D4 et D5 étant polarisées en inverse.

Les phases I, III et V, dans lesquelles la tension Vp est stable, correspondent respectivement à :
une phase I pendant laquelle l'interrupteur M1 est fermé et la diode D3 est polarisée en direct (l'interrupteur M2 étant ouvert et les diodes D4 et D5 étant polarisées en inverse), la tension Vp valant alors Ve-Vs, correspondant à une valeur maximale ;
une phase III pendant laquelle les interrupteurs M1 et M2 restent ouverts, mais les diodes D3 et D5 sont polarisées en direct (la diode D4 étant polarisée en inverse), la tension Vp vaut alors -Vs, correspondant à une valeur minimale ; et
une phase V pendant laquelle l'interrupteur M2 est fermé et les diodes D2 et D4 sont polarisées en direct (l'interrupteur M1 étant ouvert et les diodes D3 et D5 étant polarisées en inverse), la tension Vp valant alors Vs, correspondant à une valeur intermédiaire.

Dans le cycle illustré en figure 7, le maximum (1) de déformation d est à l'instant t0 de commutation de la phase VI à la phase I et le minimum (-1) de déformation d est à l'instant t3 de commutation de la phase III à la phase IV.

Le courant motionnel i a une allure sinusoïdale de même période que la déformation d. Il passe par zéro aux instants t0 (entre les phases VI et I) et t3 (entre les phases III et IV).

En variante, les diodes D2, D3, D4, D5 sont remplacées par des interrupteurs, par exemple des transistors MOS, commandés en redressement synchrone, c'est-à-dire selon le signe de la tension et/ou du courant à leurs bornes afin de respecter le fonctionnement souhaité.

Selon un autre exemple, en se référant au schéma de la figure 3, on peut obtenir un convertisseur abaisseur, opérationnel pour toute tension continue Ve supérieure à la tension Vs avec la commande suivante des interrupteurs K1 à K5 :
des phases II, IV et VI de transition dans lesquelles tous les interrupteurs sont ouverts ;
une phase I (à tension Vp maximale) dans laquelle seuls les interrupteurs K1 et K4 sont fermés, la tension Vp vaut alors Ve ;
une phase III (à tension Vp intermédiaire) dans laquelle seuls les interrupteurs K2 et K4 sont fermés, la tension Vp vaut alors Vs ; et
une phase V (à tension Vp minimale) dans laquelle seuls les interrupteurs K3 et K5 sont fermés, la tension Vp vaut alors -Vs.

Par rapport aux réalisations des figures 4 et 5, l'élément piézoélectrique 4 n'est, en figure 7 ou selon la commande ci-dessus, jamais court-circuité, c'est-à-dire qu'il n'y a pas de phase stable dans laquelle la tension à ses bornes est nulle.

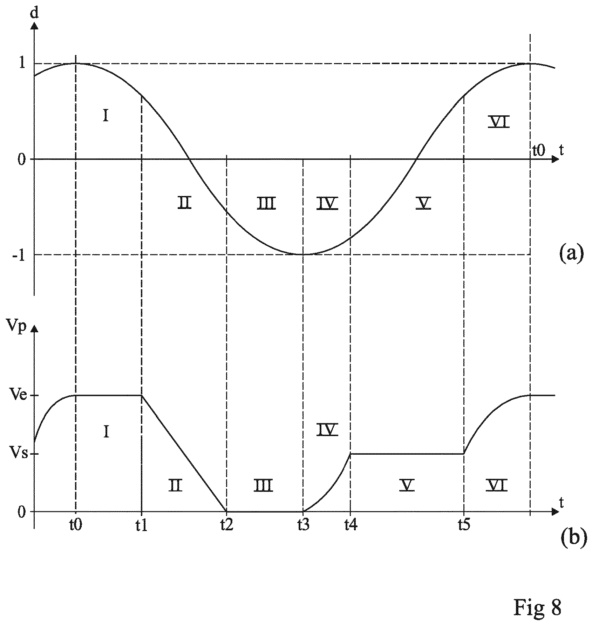

La figure 8 illustre, par des chronogrammes schématiques, un autre mode de réalisation d'un convertisseur abaisseur, basé sur le montage de la figure 3.

Plus précisément, la figure 8 illustre un cas dans lequel on prévoit une phase stable à tension Vp nulle aux bornes de l'élément 4.

La vue (a) de la figure 8 illustre un exemple de déformation mécanique d de l'élément piézoélectrique 4. L'échelle de déformation d est normalisée sur une période d'oscillation de l'élément piézoélectrique.

La vue (b) de la figure 8 illustre l'allure correspondante de la tension Vp aux bornes de l'élément piézoélectrique 4 au cours d'un cycle (une période) de résonance. Les échelles de tension Vp et de temps t sont arbitraires.

Dans le mode de réalisation de la figure 8, outre les trois phases de transition II, IV et VI, on a :
une phase I (à tension Vp maximale) dans laquelle seuls les interrupteurs K1 et K4 sont fermés, la tension Vp vaut alors Ve ;
une phase III (à tension Vp minimale) dans laquelle les interrupteurs K2 et K3 (et/ou les interrupteurs K4 et K5) sont fermés, la tension Vp vaut alors 0 ; et
une phase V (à tension Vp intermédiaire) dans laquelle les interrupteurs K2 et K4 sont fermés, la tension Vp vaut alors Vs.

Dans l'exemple de la figure 8, la régulation s'effectue en réglant la durée de la phase I.

La détermination des différents instants de commutation en mode abaisseur peut utiliser les mêmes techniques que celles décrites pour un convertisseur élévateur, par exemple compteur temporel, mesure de tension de sortie, de tension aux bornes de l'élément 4, détection d'inversion de sens du courant, de sens de la déformation, etc.

Le montage de la figure 3 peut également être commandé pour fonctionner en inverseur de tension avec une tension Vs de signe opposé à celui de la tension Ve (en conservant le niveau de référence comme étant celui des bornes 24 et 28).

Selon un exemple de réalisation, applicable pour une tension d'entrée Ve négative, de valeur absolue supérieure à la tension Vs positive souhaitée, outre les trois phases de transition II, IV et VI dans lesquelles tous les interrupteurs sont ouverts, on a :
une phase I (à tension Vp maximale) dans laquelle seuls les interrupteurs K2 et K4 sont fermés, la tension Vp valant alors Vs ;
une phase III (à tension Vp minimale) dans laquelle les interrupteurs K1 et K4 sont fermés, la tension Vp valant alors Ve ; et
une phase V (à tension Vp intermédiaire) dans laquelle les interrupteurs K3 et K5 sont fermés, la tension Vp valant alors -Vs.

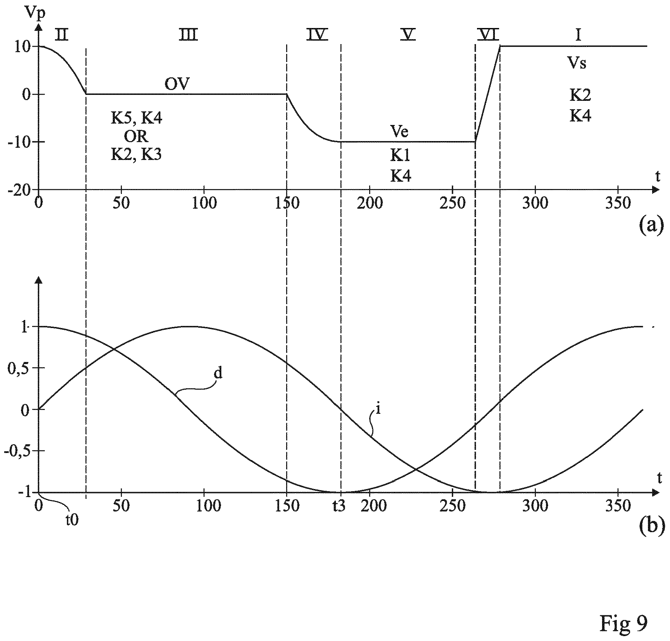

La figure 9 illustre, par des chronogrammes schématiques, un autre mode de réalisation d'un convertisseur inverseur d'une tension Ve négative en une tension Vs positive, basé sur le montage de la figure 3.

La vue (a) de la figure 9 illustre un exemple d'allure de la tension Vp aux bornes de l'élément piézoélectrique 4 au cours d'un cycle (une période) de résonance. Les échelles de tension Vp et de temps t sont arbitraires. Dans l'exemple de la figure 9, on suppose une tension d'entrée Ve de -10 volts et une tension de sortie Vs souhaitée de 10 volts.

La vue (b) de la figure 9 illustre la déformation mécanique d de l'élément piézoélectrique 4 et la valeur du courant motionnel i dans l'élément piézoélectrique 4. Les échelles de déformation d et de courant i sont normalisées sur une période d'oscillation de l'élément piézoélectrique.

Outre les trois phases de transition II, IV et VI dans lesquelles tous les interrupteurs sont ouverts, on a :
une phase I dans laquelle seuls les interrupteurs K2 et K4 sont fermés, la tension Vp valant alors Vs ;
une phase III dans laquelle les interrupteurs K2 et K5 (et/ou K2 et K3) sont fermés, la tension Vp valant alors 0 ; et
une phase V dans laquelle les interrupteurs K1 et K4 sont fermés, la tension Vp valant alors Ve.

Dans le cycle illustré en figure 9, le maximum (1) de déformation d est à l'instant t0 de commutation de la phase I à la phase II et le minimum (-1) de déformation d est à l'instant t3 de commutation de la phase IV à la phase V.

Le courant motionnel i a une allure sinusoïdale de même période que la déformation d. Il passe par zéro aux instants t0 (entre les phases I et II) et t3 (entre les phases IV et V).

L'architecture décrite en relation avec la figure 3 peut également servir à effectuer une conversion alternative-continue.

Selon un mode de réalisation, dans lequel la fréquence de résonance de l'élément piézoélectrique 4 est supérieure, de préférence dans un rapport d'au moins 50, à la fréquence de la tension alternative d'entrée, on peut considérer que la tension alternative d'entrée est sensiblement constante sur une ou quelques périodes de résonance de l'élément piézoélectrique. Le système fonctionne alors comme si l'on avait une succession temporelle de conversions DC-DC avec une tension d'entrée qui varie lentement. Les interrupteurs sont commandés de manière à respecter, pour chaque période de la résonance de l'élément piézoélectrique, l'équilibre de charge, l'équilibre d'énergie et les commutations à zéro de tension. La durée des phases du cycle et la commande des interrupteurs s'adaptent donc dynamiquement avec l'évolution de la valeur de la tension sinusoïdale d'entrée.

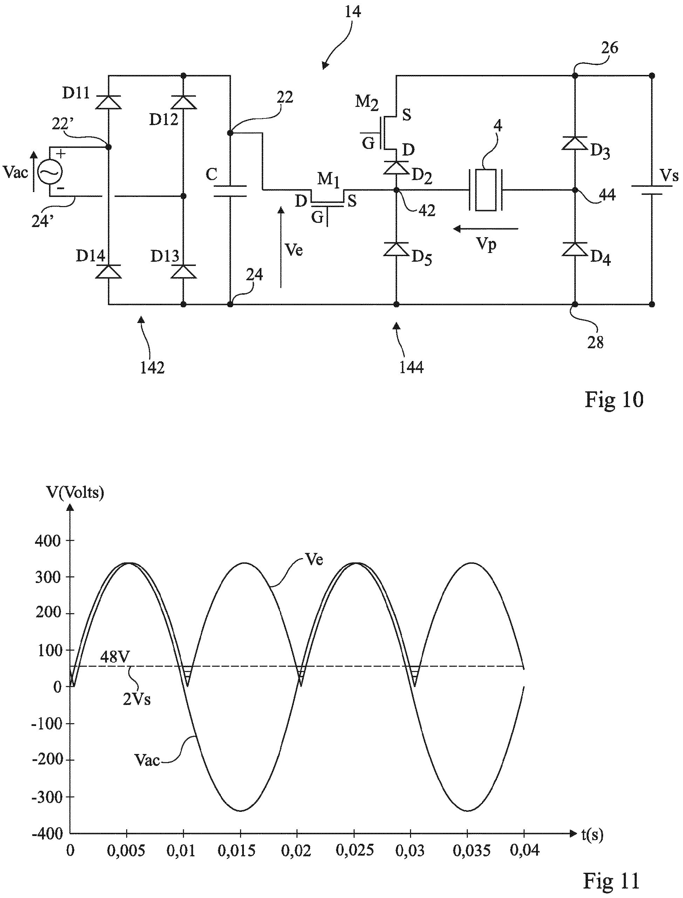

La figure 10 représente, de façon schématique, un mode de réalisation d'un convertisseur alternatif-continu respectant l'architecture de la figure 3.

Dans le mode de réalisation de la figure 10, le convertisseur AC/DC est du type du convertisseur 14 de la vue (b) de la figure 2, c'est-à-dire qu'il comporte un étage de redressement 142 et un étage de conversion DC/DC 144.

L'étage de redressement 142 est, par exemple, un pont redresseur à diodes D11, D12, D13 et D14, dont deux bornes d'entrée alternatives sont reliées, de préférence connectées, aux bornes 22' et 24' d'application de la tension alternative Vac et dont deux bornes de sortie redressées sont reliées, de préférence connectées, aux bornes 22 et 24 d'entrée de l'étage de conversion 144. Un condensateur C relie, de préférence connecte, les bornes 22 et 24 pour filtrer la tension redressée avant conversion. Les diodes D11 et D14 sont en série entre les bornes 22 et 24, le point milieu de l'association en série étant relié, de préférence connecté, à la borne 22', l'anode de la diode D11 et la cathode de la diode D14 étant côté borne 22'. Les diodes D12 et D13 sont en série entre les bornes 22 et 24, le point milieu de l'association en série étant relié, de préférence connecté, à la borne 24', l'anode de la diode D12 et la cathode de la diode D13 étant côté borne 24'.

L'étage de conversion 144 reprend, dans cet exemple, la structure du convertisseur 12 de la figure 6.

Dans ce mode de réalisation, la commande cyclique est effectuée tant que la tension redressée Ve est supérieure à deux fois la valeur souhaitée pour la tension Vs. Hors de ces périodes, on tire profit du fait qu'un élément piézoélectrique présente un facteur de qualité élevée (généralement supérieur à 1000). Ainsi, lorsque la valeur absolue de la tension Ve devient inférieure à deux fois la valeur souhaitée pour la tension Vs, le convertisseur peut continuer à fournir la tension Vs au niveau et avec la puissance souhaitée grâce à l'énergie mécanique accumulée dans l'élément piézoélectrique.

La figure 11 illustre, par des chronogrammes, un exemple pratique de fonctionnement du convertisseur de la figure 10.

Cette figure représente un exemple d'allures de la tension alternative d'entrée Vac, l'allure correspondante de la tension Ve d'entrée de l'étage de conversion 144 (tension Vac redressée) et, en pointillés, le double (2Vs) de la tension continue Vs souhaitée. On suppose le cas pratique d'une tension Vac correspondant au secteur (environ 230 volts, 50-60 Hertz).

Dans de nombreuses applications, la tension Vs est tout au plus de quelques dizaines de volts (24 volts dans l'exemple de la figure 11). La figure 11 fait alors ressortir que l'amplitude crête à crête de la tension Vac est suffisamment grande (rapport d'au moins environ 10) par rapport à la tension Vs souhaitée pour que les périodes pendant lesquelles l'étage de conversion 144 ne reçoit pas d'énergie (Ve < 2Vs) soient négligeables (de l'ordre de 10 % du temps). Ces périodes correspondent aux parties hachurées en figure 11.

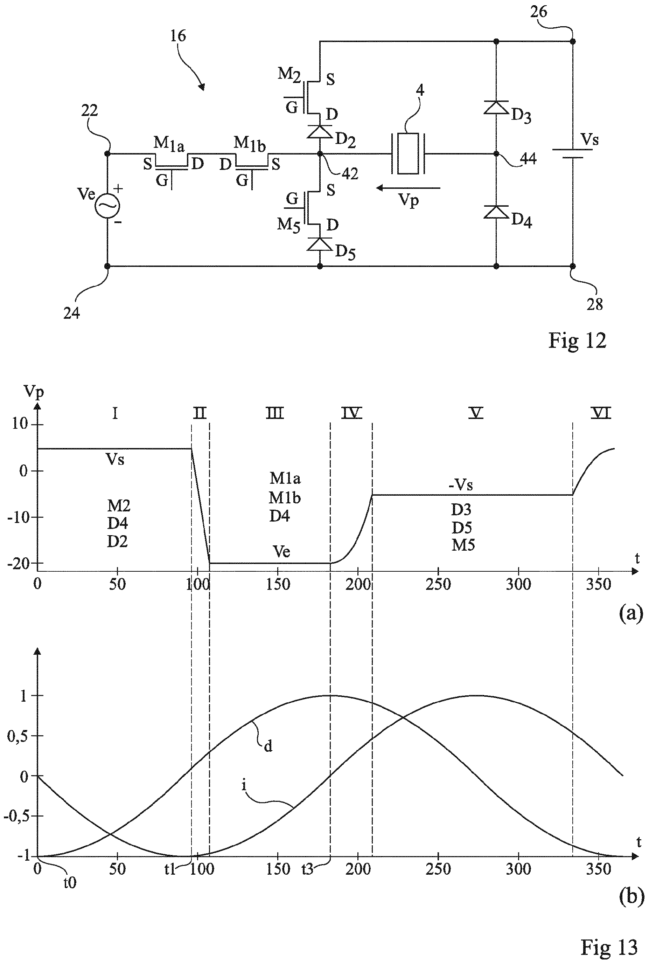

La figure 12 représente un autre mode de réalisation d'un convertisseur alternatif-continu respectant l'architecture de la figure 3.

Le mode de réalisation de la figure 12 correspond au mode de réalisation d'un convertisseur 16 (vue (c) de la figure 2) dans lequel le pont 6 d'interrupteurs est commandé pour effectuer le redressement de la tension alternative, c'est-à-dire qui accepte des valeurs négatives de la tension d'entrée Ve.

La structure du convertisseur 16 reprend les éléments du convertisseur 12 de la figure 6 à ceci près qu'un transistor M5 est ajouté en série avec la diode D5 entre les bornes 28 et 42 pour obtenir un interrupteur K5 bidirectionnel en tension (tenant les tensions positives et négatives) et que le transistor M1 de la figure 6 est remplacé par deux transistors MOS M1a et M1b en série, montés tête-bêche, pour assurer la fonction d'un interrupteur K1 bidirectionnel en tension.

Dans l'exemple de la figure 12, la source du transistor M5 est côté borne 42 et les sources S des transistors M1a et M1b sont respectivement côté borne 22 et côté borne 42. Les transistors M1a et M1b sont donc à drain D commun. En variante, les transistors M1a et M1b sont à source commune.

Le cycle de commande appliqué à la commande des transistors dépend de la valeur de la tension d'entrée Ve.

Quand la tension Ve est (positive et) supérieure à 2Vs, on applique le cycle de commande illustré par la figure 7, les transistors M1a et M1b étant fermés pendant la phase I, le transistor M5 étant fermé pendant la phase III et le transistor M2 étant fermé pendant la phase V. La tension Ve peut être considérée comme stable à l'échelle d'une période de déformation de l'élément piézoélectrique qui est faible (rapport d'au moins 100) devant la période de la tension Ve.

Quand la tension Ve est (négative et) inférieure à -Vs, on applique un cycle de commande tel que représenté en figure 13 ci-dessous.

La figure 13 illustre, par des chronogrammes, un mode de commande des interrupteurs du convertisseur de la figure 12.

Plus précisément, la figure 13 illustre un exemple de commande des transistors M1a, M1b, M2 et M5 pour obtenir un fonctionnement en convertisseur (abaisseur) continu-continu lorsque la tension d'entrée est négative et inférieure à l'opposé de la tension de sortie souhaitée.

La vue (a) de la figure 13 illustre un exemple d'allure de la tension Vp aux bornes de l'élément piézoélectrique 4 au cours d'un cycle (une période) de résonance. Les échelles de tension Vp et de temps t sont arbitraires. Dans l'exemple de la figure 13, on suppose une tension Vs de 5 volts et une tension Ve qui est sensiblement stable, par exemple au niveau -20 volts pendant la période de déformation considérée.

La vue (b) de la figure 13 illustre la déformation mécanique d de l'élément piézoélectrique 4 et la valeur du courant motionnel i dans l'élément piézoélectrique 4. Les échelles de déformation d et de courant i sont normalisées.

On retrouve les six phases I, II, III, IV, V et VI de fonctionnement illustrées en relation avec la figure 7. Toutefois, les paliers de tension sont ici à Vs (maximum), Ve (minimum) et -Vs (intermédiaire).

Les phases I, III et V, dans lesquelles la tension Vp est stable, correspondent respectivement à :
une phase I pendant laquelle l'interrupteur M2 est fermé et les diodes D2 et D4 sont polarisées en direct (les interrupteurs M1a, M1b et M5 étant ouverts et la diode D3 étant polarisée en inverse), la tension Vp valant alors Vs ;
une phase III pendant laquelle les interrupteurs M1a et M1b sont fermés et la diode D4 est polarisée en direct (les interrupteurs M2 et M5 étant ouverts et la diode D3 étant polarisée en inverse), la tension Vp valant alors Ve ; et
une phase V pendant laquelle l'interrupteur M5 est fermé et les diodes D3 et D5 sont polarisées en direct (les interrupteurs M1a, M1b et M2 étant ouverts et la diode D4 étant polarisée en inverse), la tension Vp valant alors -Vs.

Dans le cycle illustré en figure 13, le maximum (1) de déformation d est à l'instant t3 de commutation de la phase III à la phase IV et le minimum (-1) de déformation d est à l'instant t0 de commutation de la phase VI à la phase I.

Le courant motionnel i a une allure sinusoïdale de même période que la déformation d. Il passe par zéro aux instants t0 (entre les phases VI et I) et t3 (entre les phases III et IV).

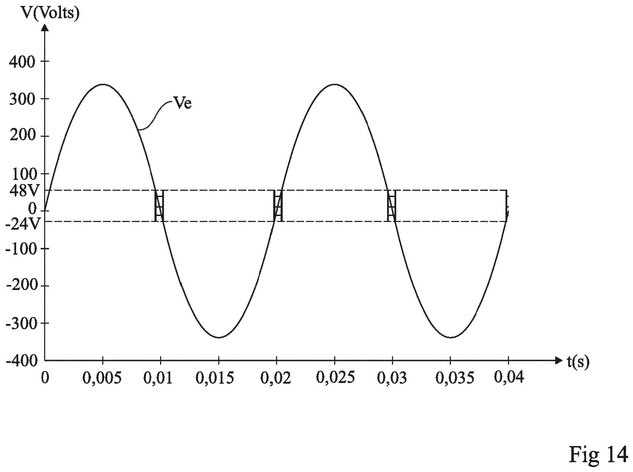

La figure 14 illustre, par un chronogramme, le fonctionnement du convertisseur 16 de la figure 12, à l'échelle de la fréquence de la tension alternative Ve du secteur.

En supposant une tension de sortie souhaitée Vs de l'ordre de 24 volts, le convertisseur n'est pas suffisamment alimenté entre 48 volts et -24 volts pour garantir un équilibre d'énergie du point de vue de l'élément piézoélectrique sur une période de résonance. Cependant, l'élément piézoélectrique 4 a accumulé de l'énergie auparavant et continue de résonner avec une amplitude décroissante (bilan d'énergie négatif sur une période de résonance) permettant de maintenir une partie des échanges d'énergie (zones hachurées en figure 14). Pendant les alternances positives et pour une tension Ve supérieure à 48 volts (2Vs), le convertisseur fonctionne (est commandé) selon le cycle de la figure 7. Pendant les alternances négatives et pour une tension Ve inférieure à -24 volts (-Vs), le convertisseur fonctionne (est commandé) selon le cycle de la figure 13.

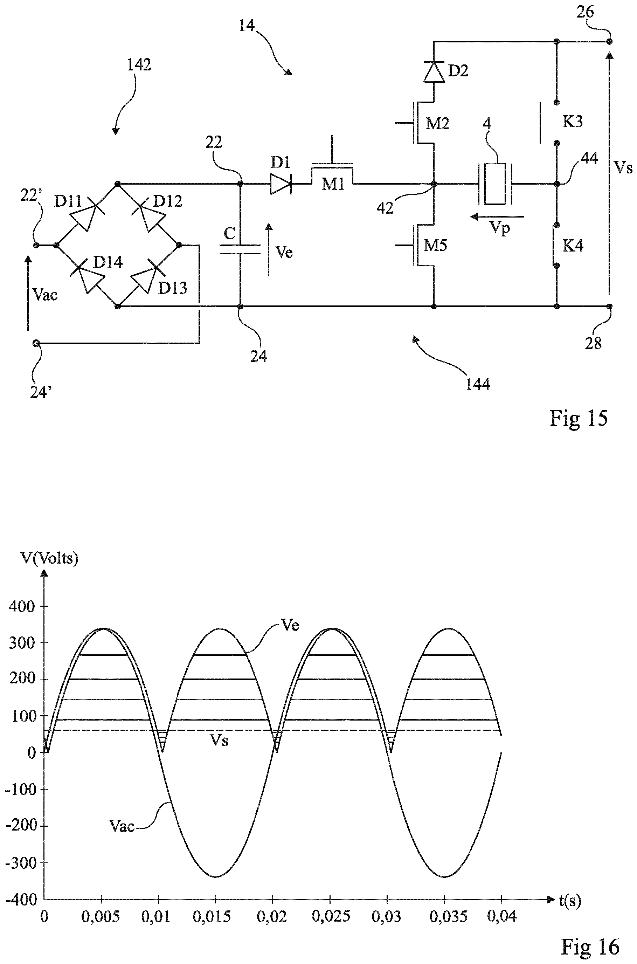

La figure 15 représente un autre mode de réalisation d'un convertisseur alternatif-continu 14 basé sur le mode de réalisation de la vue (b) de la figure 2, c'est-à-dire avec un étage de redressement 142 et un étage de conversion 144.

Le pont 142 est similaire à celui illustré en figure 10.

Côté étage de conversion, une particularité du mode de réalisation de la figure 15 est que l'on prévoit que l'interrupteur K3 soit en permanence ouvert et que l'interrupteur K4 soit en permanence fermé. Cela peut être obtenu par commande d'interrupteurs d'une architecture telle que représentée en figure 3 ou par montage (connexion directe de la borne 44 à la borne 28) et en remplaçant l'interrupteur K3 par un circuit ouvert. Ainsi, on peut considérer que l'interrupteur K5, par exemple un transistor MOS M5, est en parallèle avec l'élément 4 et peut forcer une tension nulle entre ses bornes 42 et 44. Dans l'exemple de la figure 15, l'interrupteur M2 est constitué d'un transistor MOS M2 en série avec une diode D2 et l'interrupteur K1 est constitué d'un interrupteur M1 en série avec une diode D1.

La commande des transistors M1, M2 et M5 est effectuée selon un cycle différent selon que la tension Ve entre les bornes 22 et 24 (tension redressée et filtrée) est supérieure ou inférieure à la tension de sortie Vs souhaité.

Quand la tension Ve est supérieure à la tension Vs, on commande les interrupteurs en mode abaisseur selon le cycle illustré par la figure 8. En d'autres termes :
pendant les phases II, IV et VI, les transistors M1, M3 et M5 sont tous ouverts ;
pendant la phase I, seul l'interrupteur K1 est fermé (l'interrupteur K4 étant une connexion directe), la tension Vp vaut alors Ve ;
pendant la phase III, seul l'interrupteur K5 est fermé (l'interrupteur K4 étant une connexion directe), la tension Vp vaut alors 0 ;
pendant la phase V, seul l'interrupteur K2 est fermé (l'interrupteur K4 étant une connexion directe), la tension Vp vaut alors Vs.

Quand la tension Ve est inférieure à la tension Vs, on commande les interrupteurs en mode élévateur selon le cycle illustré par la figure 4. En d'autres termes :
pendant les phases II, IV et VI, les transistors M1, M3 et M5 sont tous ouverts ;
pendant la phase I, seul l'interrupteur K2 est fermé (l'interrupteur K4 étant une connexion directe), la tension Vp vaut alors Vs ;
pendant la phase III, seul l'interrupteur K1 est fermé (l'interrupteur K4 étant une connexion directe), la tension Vp vaut alors Ve ;
pendant la phase V, seul l'interrupteur K5 est fermé (l'interrupteur K4 étant une connexion directe), la tension Vp vaut alors 0.
La figure 16 illustre, par des chronogrammes, le fonctionnement du convertisseur 14 de la figure 15, à l'échelle de la fréquence de la tension alternative du secteur.
La figure 16 représente un exemple d'allure de la tension sinusoïdale Vac et l'allure correspondante de la tension redressée Ve.

Des hachures horizontales indiquent les périodes respectives pendant lesquelles la commande est effectuée selon le cycle de la figure 8 (tension Ve supérieure à Vs) et selon le cycle de la figure 4 (tension Ve inférieure à Vs).

On peut considérer que, pour les modes de réalisation alternatif-continu, on convertit une tension d'entrée sinusoïdale d'amplitude Vac, de basse fréquence par rapport à la fréquence de résonance de l'élément piézoélectrique 4, en une tension de sortie continue de valeur inférieure ou supérieure à la valeur de la tension Vac selon l'instant considéré dans la période de la tension d'entrée. On applique alors un cycle de conversion selon les principes d'un convertisseur DC-DC (équilibre de charge, équilibre d'énergie et commutations à zéro de tension) à chaque période de résonance du piézoélectrique, en considérant la tension d'entrée Ve sensiblement constante sur une période de résonance piézoélectrique. Le pont redresseur est optionnel mais permet de simplifier la réalisation de certains interrupteurs qui n'ont alors pas besoin d'être tous bidirectionnels en tension.

La détermination des instants de commutation dépend de l'application et du type de conversion souhaité (DC/DC, AC/DC, abaisseur, élévateur, inverseur). Par exemple, pour un système dans lequel la puissance ou le courant de sortie est connu, l'utilisation de temporisations permet d'éviter des mesures. Selon un autre exemple, on mesure certains niveaux de tension et on les compare à des seuils et/ou la déformation de l'élément piézoélectrique (capteurs d'extrema).

De façon générale, la durée de la phase III conditionne la quantité de charges qui sera retirée du piézoélectrique à tension minimale. Plus cette phase III est longue, moins on retire d'énergie du piézoélectrique et plus on favorise un cycle avec un bilan d'énergie positif. Plus le bilan d'énergie est positif, plus l'amplitude de déformation du piézoélectrique augmente d'un cycle à l'autre et plus la puissance/le courant de sortie finira par être élevé.

Pour amorcer le système (régime transitoire), on ne ferme que certains des interrupteurs, notamment en mode élévateur de tension, jusqu'à ce que l'amplitude des oscillations mécaniques de l'élément piézoélectrique soit suffisante pour effectuer le cycle de conversion. En mode élévateur, on peut également passer aux six phases de fonctionnement dès que la tension Vp est supérieure à la tension Ve. La fin du régime transitoire a lieu lorsque la tension de sortie Vs atteint sensiblement la valeur souhaitée. La détermination des commutations en régime transitoire dépend du mode de fonctionnement choisi et se déduit des explications du régime permanent du mode de fonctionnement concerné.

Le fait de prévoir un fonctionnement à fréquence sensiblement constante permet de préserver un fonctionnement de l'élément piézoélectrique à la résonance. Cela permet de ne pas dégrader son facteur de qualité et ainsi d'optimiser le rendement.

On notera que l'élément piézoélectrique n'a pas besoin d'être polarisé, et que le fait de prévoir, entre chaque phase à tension constante, une phase dans laquelle tous les interrupteurs sont ouverts entrainant une variation de la tension aux bornes de l'élément piézoélectrique, participe à la réduction de pertes de commutation, notamment par une commutation au zéro de tension.

Un autre avantage des modes de réalisation décrits est qu'ils ne sont pas limités à un facteur particulier entre la valeur de la tension d'entrée et celle de la tension de sortie.

Pour un matériau piézoélectrique donné, on connait sa fréquence de résonance. Selon sa forme, on connait également l'amplitude maximale de ses oscillations avant saturation. A cette amplitude maximale correspond un courant maximal de court-circuit, ce qui donne sensiblement le courant maximal qui pourra être fourni à la sortie durant la phase I. De même, à cette amplitude maximale, correspond une tension à vide maximale qui donne sensiblement les tensions maximales que les tensions d'entrée ou de sortie pourront atteindre.

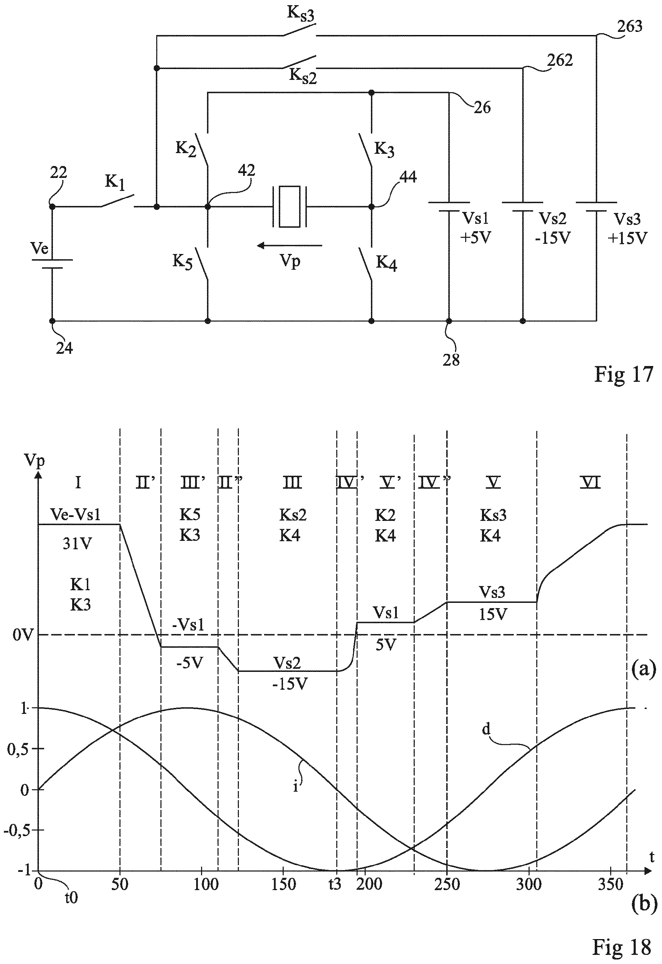

La figure 17 représente le schéma d'un mode de réalisation permettant de fournir, à partir d'un même élément piézoélectrique 4 et d'un même pont 6, plusieurs tensions de sortie.

Dans l'exemple de la figure 17, on suppose le cas d'une fourniture de trois tensions de sortie Vs1, Vs2 et Vs3, toutes référencées par rapport à la même borne 28 (confondue avec la borne 24).

L'architecture reprend le montage de la figure 3 (interrupteurs K1 à K5). En outre, un interrupteur Ks2 relie la borne 42 à une borne positive 262 de fourniture de la tension Vs2 et un interrupteur Ks3 relie la borne 42 à une borne positive 263 de fourniture de la tension Vs3, la tension Vs1 étant fournie entre les bornes 26 et 28.

La figure 18 illustre, par des chronogrammes, un mode de commande des interrupteurs du convertisseur de la figure 17 pour obtenir un fonctionnement en convertisseur abaisseur continu-continu.

La vue (a) de la figure 18 illustre un exemple d'allure de la tension Vp aux bornes de l'élément piézoélectrique 4 au cours d'un cycle (une période) de résonance. Les échelles de tension Vp et de temps t sont arbitraires. Dans l'exemple de la figure 17, on suppose des tensions Vs1 de 5 volts, Vs2 de -15 volts et Vs3 de 15 volts, et une tension Ve de l'ordre de 36 volts.

La vue (b) de la figure 18 illustre la déformation mécanique d de l'élément piézoélectrique 4 et la valeur du courant motionnel i dans l'élément piézoélectrique 4. Les échelles de déformation d et de courant i sont normalisées.

Pour obtenir trois tensions de sortie, un cycle comporte dix phases.

On retrouve les phases stables I, III et V, respectivement de niveau maximum (Ve-Vs1), minimum (Vs2) et intermédiaire (Vs3).

On retrouve également des phases de transition dans lesquelles tous les interrupteurs sont ouverts. Toutefois, les phases II et IV sont chacune divisées en deux, respectivement II', II'' et IV', IV'', afin d'obtenir deux paliers supplémentaires, respectivement de niveau -Vs1 (phase III') et de niveau Vs1 (phase V'). La phase VI entre le niveau intermédiaire V et le niveau I n'est pas modifiée.

Les états respectifs des interrupteurs pendant les phases stables sont respectivement :
interrupteurs K1 et K3 fermés pendant la phase I, la tension Vp valant alors Ve-Vs1;
interrupteurs K3 et K5 fermés pendant la phase III', la tension Vp valant alors -Vs1;
interrupteurs Ks2 et K4 fermés pendant la phase III, la tension Vp valant alors Vs2 ;
interrupteurs K2 et K4 fermés pendant la phase V', la tension Vp valant alors Vs1 ; et
interrupteurs Ks3 et K4 fermés pendant la phase V, la tension Vp valant alors Vs3.

Dans le cycle illustré en figure 18, le maximum (1) de déformation d est à l'instant t0 de commutation de la phase IV à la phase I et le minimum (-1) de déformation d est à l'instant t3 de commutation de la phase III à la phase IV'.

Le courant i a une allure sinusoïdale de même période que la déformation d. Il passe par zéro aux instants t0 et t3.

Le mode de réalisation des figures 17 et 18 illustre le fait que les modes de réalisation décrits ne sont pas limités au cas d'une tension d'entrée, une tension de sortie et trois phases à tension Vp constante. En pratique, on peut prévoir un nombre quelconque de tensions d'entrée et/ou de sortie et un nombre quelconque d'alternances tension constante/charge constante à l'intérieur d'une période de résonance de l'élément piézoélectrique.

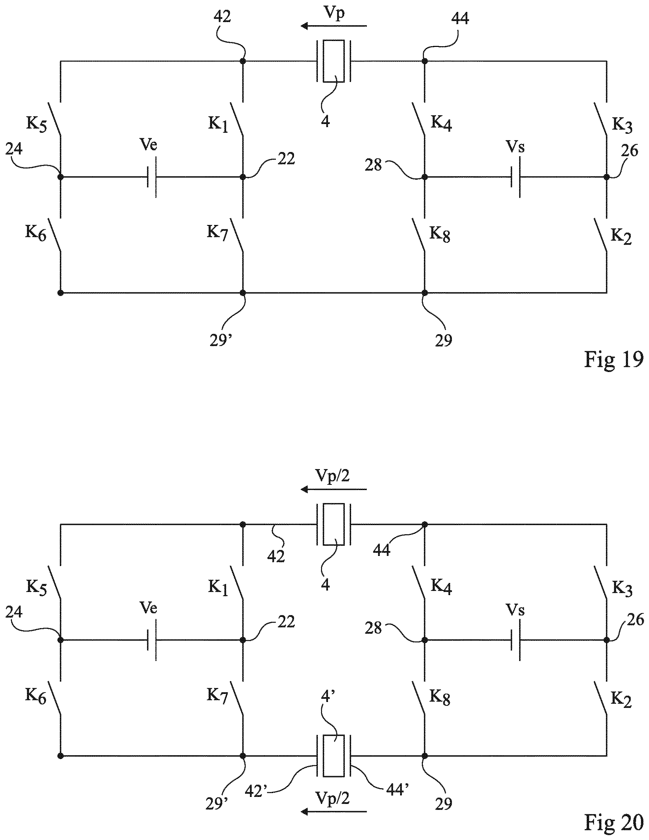

La figure 19 représente, de façon très schématique, un autre mode de réalisation d'une architecture de convertisseur.

On retrouve l'élément piézoélectrique 4 et les interrupteurs K1, K3, K4 et K5 connectés, de la même façon qu'en figure 3, aux bornes 22, 24 d'application de la tension Ve et aux bornes 26 et 28 de fourniture de la tension Vs.

Toutefois, l'interrupteur K2 ne relie pas directement les bornes 42 et 26, mais relie la borne 26 à un premier noeud intermédiaire 29. Ce noeud 29 est relié, par un interrupteur K8, à la borne 28.

Dans l'exemple de la figure 19, le noeud 29 est connecté à un deuxième noeud 29' qui est relié, par un interrupteur K6, à la borne 24, et, par un interrupteur K7, à la borne 22.

On dispose alors de structures de commutation de même nature côté tension Ve et côté tension Vs. Il est alors plus facile d'intervertir leurs rôles respectifs.

On retrouve néanmoins la structure en pont en H avec l'élément piézoélectrique dans la barre du H, mais avec cette fois ci les branches du H constituées respectivement des interrupteurs K1 et K5 en série et des interrupteurs K3 et K4 en série, les bornes d'entrée 22 et 24 et de sortie 26 et 28 du convertisseur correspondant aux extrémités de ces branches.

La liste des valeurs que peut prendre la tension Vp en fonction des valeurs des tensions Ve et Vs selon la configuration des interrupteurs de la figure 19 dans un cycle de commande est :
Vp = 0V :
   interrupteurs K1 et K7 ou interrupteurs K5 et K6 fermés ;
   interrupteurs K4 et K8 ou interrupteurs K2 et K3 fermés ; et
   les autres interrupteurs ouverts.
Vp = Ve :
   interrupteurs K1 et K6 fermés ;
   interrupteurs K4 et K8 ou interrupteurs K2 et K3 fermés ; et
   les autres interrupteurs ouverts.
Vp = -Ve :
   interrupteurs K5 et K7 fermés ;
   interrupteurs K4 et K8 ou interrupteurs K2 et K3 fermés ; et
   les autres interrupteurs ouverts.
Vp = Vs :
   interrupteurs K1 et K7 ou interrupteurs K5 et K6 fermés ;
   interrupteurs K2 et K4 fermés ; et
   les autres interrupteurs ouverts.
Vp = -Vs :
   interrupteurs K1 et K7 ou interrupteurs K5 et K6 fermés ;
   interrupteurs K3 et K8 fermés ; et
   les autres interrupteurs ouverts.
Vp = Ve-Vs :
   interrupteurs K1, K6, K3 et K8 fermés ; et
   les autres interrupteurs ouverts.
Vp = Vs-Ve :
   interrupteurs K5, K7, K4 et K2 fermés ; et
   les autres interrupteurs ouverts.
Vp = Ve+Vs :
   interrupteurs K1, K6, K4 et K2 fermés ; et
   les autres interrupteurs ouverts.
Vp = -Ve-Vs :
   interrupteurs K5, K7, K3 et K8 fermés ; et
   les autres interrupteurs ouverts.

Un tel montage permet ainsi de couvrir tous les cas de conversion, à savoir l'inversion ou non de tension, l'élévation ou l'abaissement de tension, la permutation de l'entrée/sortie, c'est-à-dire le transfert de puissance de l'entrée vers la sortie ou inversement. Par ailleurs, l'augmentation du choix dans les niveaux de tension applicables permet d'optimiser le rendement à chaque instant en fonction des valeurs des tensions d'entrée et de sortie. Il est par ailleurs possible de générer en sortie une tension alternative à une fréquence différente de la tension d'entrée (mais toujours à une fréquence très inférieure à la fréquence de résonance du piézoélectrique) en adaptant à chaque instant le rapport de transformation et la nature de la conversion (inversion de tension ou non).

La figure 20 représente, de façon très schématique, encore un autre mode de réalisation d'une architecture de convertisseur.

Cette architecture est basée sur celle de la figure 19, mais on prévoit d'utiliser un deuxième élément piézoélectrique 4' entre les noeuds 29 et 29'. Cela revient à placer deux éléments piézoélectriques 4 et 4' sensiblement identiques en série (ils sont parcourus par le même courant).

La tension totale Vp appliquée se sépare en deux et chacun des piézoélectriques voit Vp/2. Chacun des cycles présentés dans le document sont applicable de la même manière.

Les commandes des interrupteurs K1 à K8 sont adaptées au mode de fonctionnement (abaisseur, élévateur, inverseur), les différents cycles de commande décrits ci-dessus étant applicables à cette architecture.

Pour s'assurer du fonctionnement synchronisé des deux éléments piézoélectriques, il peut être avantageux de disposer d'un lien mécanique entre les deux éléments (par exemple, on peut prévoir de les coller et/ou de les serrer l'un à l'autre, de les réaliser sur une même céramique, de les disposer sur un même substrat ou une même carte de circuit imprimé, etc.).

Un avantage qu'il y a à utiliser deux éléments piézoélectriques comme illustré en figure 20 est que la tension de sortie Vs est ainsi isolée de la tension d'entrée Ve, sans pour autant qu'il soit nécessaire d'utiliser un transformateur. On évite ainsi les pertes engendrées par le transformateur. Cet avantage est présent même par rapport à un transformateur piézoélectrique, dans lequel toute l'énergie apportée au primaire n'est pas complètement transmise au secondaire et le primaire doit par ailleurs mettre en mouvement une masse plus grande, à savoir celle du primaire plus celle du secondaire, ce qui engendre des pertes.

Dans le mode de réalisation de la figure 20, l'isolation est assurée par le fait que l'impédance électrique des éléments piézoélectriques 4 et 4' est très élevée à basse fréquence (par exemple, à 50 ou 60 Hz correspondant à la fréquence du réseau électrique). En effet, à basse fréquence devant la fréquence de résonance du piézoélectrique (par exemple, de l'ordre de quelques centaines de kHz, voire de l'ordre de quelques MHz), l'impédance d'un élément piézoélectrique est de l'ordre du Mégohms. La partie à droite des deux éléments piézoélectriques (côté sortie Vs) se trouve donc isolée de la partie gauche (côté entrée Ve) via l'impédance élevée que ces deux éléments représentent à basse fréquence par rapport à leur fréquence de résonance.

En variante, un des deux éléments piézoélectriques 4 et 4' est remplacé par une simple capacité de liaison dont le but est de ne pas laisser passer la composante continue et la basse fréquence (<500Hz). Cette capacité ne sert alors qu'à l'isolation basse fréquence et ne contribue pas à la fonction de conversion d'énergie. Cette capacité, peut être constituée de tout nombre de capacités élémentaires placées en série et/ou parallèle, par exemple pour assurer une fonction de redondance et/ou de sécurité.

De façon similaire, un élément piézoélectrique peut être constitué d'un nombre quelconque d'éléments piézoélectriques élémentaires placés en série et/ou parallèle. De préférence, ces éléments piézoélectriques élémentaires résonnent à une fréquence proche les uns des autres. De préférence, ils sont couplés mécaniquement.

L'architecture décrite en relation avec les figures 19 et 20 correspond à prévoir quatre branches d'interrupteurs ayant chacune au moins deux interrupteurs en série. Une première branche (interrupteurs K1 et K7 en série) et une deuxième branche (interrupteurs K5 et K6 en série) sont en parallèle entre une première borne 42 et une deuxième borne 29'. Les points-milieux respectifs des première et deuxième branches sont reliés, de préférence connectés, aux bornes 22 et 24 d'application de la tension d'entrée Ve. Une troisième branche (interrupteurs K3 et K2 en série) et une quatrième branche (interrupteurs K4 et K8 en série) sont en parallèle entre une troisième borne 44 et une quatrième borne 29. Les points-milieux respectifs des troisième et quatrième branches sont reliés, de préférence connectés, aux bornes 26 et 28 de fourniture de la tension de sortie Vs. Dans le mode de réalisation de la figure 19, un élément piézoélectrique 4 relie la première borne 42 à la troisième borne 44, et la deuxième borne 29' et quatrième borne 29 sont interconnectées. Selon une variante de la figure 19 non représentée, un élément capacitif relie la deuxième borne 29' à la quatrième borne 29. Dans le mode de réalisation de la figure 20, un premier élément piézoélectrique 4 relie la première borne 42 à la troisième borne 44, et un deuxième élément piézoélectrique 4' relie la deuxième borne 29' à la quatrième borne 29.

Les modes de réalisation des figures 19 et 20, bien que comportant neuf interrupteurs, respectent les caractéristiques des autres modes de réalisation et notamment la synchronisation des cycles de commande des interrupteurs par rapport au courant interne dans l'élément piézoélectrique.

On notera que les cycles décrits dans la présente description ne fonctionnent pas avec une structure électrostatique, car la tension aux bornes de l'élément piézoélectrique passe toujours par 0 et va parfois même en tension négative.

Parmi les applications des différents modes de réalisation décrits, on peut mentionner à titre d'exemple, comme application de conversion AC/DC, les chargeurs de batteries, les alimentions d'appareils électroniques, par exemple téléphones, tablettes, ordinateurs, téléviseur, objets connectés, et parmi les applications de conversion DC/DC, la distribution d'alimentations sous différents niveaux de tension dans un appareil électronique (par exemples, les tensions d'alimentation d'une mémoire flash, d'une mémoire RAM, d'un afficheur, d'un cœur de processeur, d'un port USB, d'un lecteur CD, d'un module radio, d'un disque dur, de divers périphériques) à partir d'une alimentation principale ou d'une batterie. A titre d'exemple particulier de réalisation, un montage tel qu'illustré par la figure 20 peut servir à alimenter un port USB en basse tension, sans risque électrique pour l'utilisateur à toucher les potentiels du connecteur.

Dans les modes de réalisation exposés ci-dessus, un symbole de batterie a été utilisé pour la tension d'entrée Ve et pour la tension de sortie Vs. En pratique, il peut s'agir de n'importe quelle source de tension et de n'importe quelle charge électrique. Par ailleurs, des capacités de filtrage peuvent être disposées en parallèle entre les bornes 22 et 24 et/ou entre les bornes 26 et 28 pour stabiliser la tension.

Un avantage de l'architecture décrite est qu'elle est compatible avec de multiples fonctions de conversion.

Un autre avantage est qu'il est même possible de modifier la loi de commande des interrupteurs dans un même environnement applicatif, par exemple si les tensions Ve et Vs de l'application sont amenées à changer au cours du fonctionnement. En outre, l'entrée et la sortie du convertisseur peuvent être permutées (l'entrée Ve de la figure 3 devient la sortie Vs et vice versa).

Divers modes de réalisation et variantes ont été décrits. Certains modes de réalisation et variantes pourront être combinés et d'autres variantes et modifications apparaîtront à l'homme de l'art. En particulier, le choix des niveaux de tension dépend de l'application et du gain (supérieur ou inférieur à 1) souhaité. De plus, le choix du matériau piézoélectrique dépend également de l'application de même que la forme de l'élément afin de satisfaire les contraintes en tension, en courant, et en fréquence de résonance. Une fois l'élément piézoélectrique choisi, les intervalles de temps entre les différents cycles dépendent de la fréquence de résonance du matériau piézoélectrique.

Enfin, la mise en oeuvre pratique des modes de réalisation et variantes qui ont été décrits est à la portée de l'homme de métier à partir des indications fonctionnelles données ci-dessus. En particulier, la génération de signaux de commande appropriés est à la portée de l'homme du métier en fonction de l'application et des explications données ci-dessus pour les phases de conduction souhaitées des différents interrupteurs.

## Revendications

1. Convertisseur de puissance comportant :
une première branche et une deuxième branche d'au moins deux interrupteurs (K1, K7 ; K5, K6) en série chacune, reliées en parallèle entre une première borne (42) et une deuxième borne (29'), et dont les points-milieux sont reliés à deux bornes (22, 24) d'application d'une première tension (Ve) ;
une troisième branche et une quatrième branche d'au moins deux interrupteurs (K3, K2 ; K4, K8) en série chacune, reliées en parallèle entre une troisième borne (44) et une quatrième borne (29), et dont les points-milieux sont reliés à deux bornes (26, 28) de fourniture d'une deuxième tension (Vs) ; et
au moins un premier élément piézoélectrique (4) reliant la première borne (42) à la troisième borne (44),
dans lequel :
au moins un premier interrupteur (K1) reliant la première borne (42) à une borne (22) d'application de la première tension (Ve) ;
au moins un deuxième interrupteur (K2) reliant une borne (26) de fourniture de la deuxième tension (Vs) à la quatrième borne (29) ;
au moins un troisième interrupteur (K3) reliant la troisième borne (44) à ladite borne (26) de fourniture de la deuxième tension (Vs) ;
au moins un quatrième interrupteur (K4) reliant la troisième borne (44) à l'autre borne (28) de fourniture de la deuxième tension (Vs) ;
au moins un cinquième interrupteur (K5) reliant la première borne (42) à l'autre borne (24) d'application de la première tension (Ve) ;
au moins un sixième interrupteur (K6) reliant ladite autre borne (24) d'application de la première tension à la deuxième borne (29') ;
au moins un septième interrupteur (K7) reliant ladite borne (22) d'application de la première tension à la deuxième borne (29') ; et
au moins un huitième interrupteur (K8) reliant ladite autre borne (28) de fourniture de la deuxième tension à la quatrième borne (29) ;
dans lequel les deuxième (29') et quatrième (29) bornes sont interconnectées;
et dans lequel la fermeture de chaque interrupteur (K1, K2, K3, K4, K5, K6, K7, K8) s'effectue sous une tension approximativement nulle à ses bornes, la commande des interrupteurs (K1, K2, K3, K4, K5, K6, K7, K8) étant synchronisée par rapport au courant interne à l'élément piézoélectrique, de sorte que :
un transfert d'énergie de la première tension vers l'élément piézoélectrique intervient au moins lorsque, à la fois, les premier et sixième interrupteurs sont fermés, et soit les quatrième et huitième interrupteurs soit les deuxième et troisième interrupteurs sont fermés, les autres interrupteurs étant ouverts ; et
un transfert d'énergie de l'élément piézoélectrique vers la deuxième tension intervient au moins lorsque, à la fois, les deuxième et quatrième interrupteurs sont fermés, et soit les premier et septième interrupteurs soit les cinquième et sixième interrupteurs sont fermés, les autres interrupteurs étant ouverts.

2. Convertisseur selon la revendication 1, dans lequel les deuxième (29') et quatrième (29) bornes sont directement interconnectées.

3. Convertisseur selon la revendication 1, dans lequel au moins un élément capacitif relie la deuxième borne (29') à la quatrième borne (29).

4. Convertisseur selon la revendication 1, dans lequel au moins un deuxième élément piézoélectrique (4') relie la deuxième borne (29') à la quatrième borne (29).

5. Convertisseur selon l'une quelconque des revendications 1 à 4, dans lequel le convertisseur puissance est configuré pour commander les interrupteurs (K1, K2, K3, K4, K5, K6, K7, K8) pour alterner des phases à tension sensiblement constante et à charge sensiblement constante aux bornes (42, 44) du ou des éléments piézoélectriques (4, 4').

6. Convertisseur selon l'une quelconque des revendications 1 à 5, comportant en outre un circuit (7) de commande, en tout ou rien, de tout ou partie des interrupteurs (K1, K2, K3, K4, K5, K6, K7, K8).

7. Convertisseur selon la revendication 6, dans lequel ledit circuit (7) est apte à détecter au moins un des instants de passage par zéro du courant motionnel (i) du ou des éléments piézoélectriques (4, 4'), et à générer un signal de commande d'au moins un des interrupteurs (K1, K2, K3, K4, K5, K6, K7, K8) en fonction de l'instant de passage par zéro détecté.

8. Convertisseur selon la revendication 7, dans lequel la détection du passage par zéro du courant s'effectue par une mesure et une comparaison à zéro du courant circulant dans le ou les éléments piézoélectriques (4, 4') lors d'une phase à tension constante (III), ou par une mesure et une comparaison à zéro de la dérivée de la tension aux bornes du ou des éléments piézoélectriques (4, 4') lors d'une phase à charge constante (VI), ou par une mesure de déformation du ou des éléments piézoélectriques (4, 4') et une déduction de l'instant de passage par un extremum de déformation.

9. Convertisseur selon l'une quelconque des revendications 1 à 8, dans lequel le convertisseur est configuré pour commander les interrupteurs (K1, K2, K3, K4, K5, K6, K7, K8) de façon cyclique à fréquence approximativement constante, de préférence constante, l'alternance des phases à tension sensiblement constante et à charge sensiblement constante aux bornes du ou des éléments piézoélectriques (4, 4') étant effectuée à chaque période de résonance de l'élément piézoélectrique.

10. Convertisseur selon l'une quelconque des revendications 1 à 9, dans lequel la somme des charges échangées par le ou les éléments piézoélectriques (4, 4') sur une période de résonance est sensiblement nulle.

## Patentansprüche

1. Ein Leistungswandler, der Folgendes aufweist:
einen ersten Zweig und einen zweiten Zweig von jeweils wenigstens zwei in Reihe geschalteten Schaltern (K1, K7; K5, K6), die zwischen einem ersten Anschluss (42) und einem zweiten Anschluss (29') parallel geschaltet sind und deren Mittelpunkte mit zwei Anschlüssen (22, 24) zum Anlegen einer ersten Spannung (Ve) verbunden sind;
einen dritten Zweig und einen vierten Zweig von jeweils wenigstens zwei in Reihe geschalteten Schaltern (K3, K2; K4, K8), die zwischen einem dritten Anschluss (44) und einem vierten Anschluss (29) parallel geschaltet sind und deren Mittelpunkte mit zwei Anschlüssen (26, 28) zum Liefern einer zweiten Spannung (Vs) verbunden sind; und
wenigstens ein erstes piezoelektrisches Element (4), das den ersten Anschluss (42) mit dem dritten Anschluss (44) verbindet,
wobei:
wenigstens ein erster Schalter (K1) den ersten Anschluss (42) mit einem Anschluss (22) zum Anlegen der ersten Spannung (Ve) koppelt;
wenigstens ein zweiter Schalter (K2) einen Anschluss (26) zum Liefern der zweiten Spannung (Vs) mit dem vierten Anschluss (29) koppelt;
wenigstens ein dritter Schalter (K3) den dritten Anschluss (44) mit dem Anschluss (26) zum Liefern der zweiten Spannung (Vs) koppelt;
wenigstens ein vierter Schalter (K4) den dritten Anschluss (44) mit dem anderen Anschluss (28) zum Liefern der zweiten Spannung (Vs) koppelt;
wenigstens ein fünfter Schalter (K5) den ersten Anschluss (42) mit dem anderen Anschluss (24) zum Anlegen der ersten Spannung (Ve) koppelt;
wenigstens ein sechster Schalter (K6) den anderen Anschluss (24) zum Anlegen der ersten Spannung mit dem zweiten Anschluss (29') koppelt;
wenigstens ein siebter Schalter (K7) den Anschluss (22) zum Anlegen der ersten Spannung mit dem zweiten Anschluss (29') koppelt; und
wenigstens ein achter Schalter (K8) den anderen Anschluss (28) zum Liefern der zweiten Spannung an den vierten Anschluss (29) koppelt;
wobei der zweite (29') und der vierte (29) Anschluss miteinander verbunden sind;
und wobei das Einschalten jedes Schalters (K1, K2, K3, K4, K5, K6, K7, K8) unter einer darüber anliegenden Spannung von annähernd Null durchgeführt wird, wobei die Steuerung der Schalter (K1, K2, K3, K4, K5, K6, K7, K8) bezüglich des Stroms im Inneren des piezoelektrischen Elements synchronisiert ist, so dass:
eine Leistungsübertragung von der ersten Spannung zum piezoelektrischen Element zumindest dann erfolgt, wenn zur gleichen Zeit der erste und der sechste Schalter eingeschaltet sind und entweder der vierte und der achte Schalter oder der zweite und der dritte Schalter eingeschaltet sind, während die anderen Schalter ausgeschaltet sind; und
eine Leistungsübertragung vom piezoelektrischen Element zur zweiten Spannung zumindest dann erfolgt, wenn gleichzeitig der zweite und der vierte Schalter eingeschaltet sind und entweder der erste und der siebte Schalter oder der fünfte und der sechste Schalter eingeschaltet sind, während die anderen Schalter ausgeschaltet sind.

2. Wandler nach Anspruch 1, wobei der zweite (29') und der vierte (29) Anschluss direkt miteinander verbunden sind.

3. Wandler nach Anspruch 1, wobei wenigstens ein kapazitives Element den zweiten Anschluss (29') mit dem vierten Anschluss (29) koppelt.

4. Wandler nach Anspruch 1, wobei wenigstens ein zweites piezoelektrisches Element (4') den zweiten Anschluss (29') mit dem vierten Anschluss (29) koppelt.

5. Wandler nach einem der Ansprüche 1 bis 4, wobei der Leistungswandler konfiguriert ist zum Steuern der Schalter (K1, K2, K3, K4, K5, K6, K7, K8) zum Wechseln der Phasen bei einer im Wesentlichen konstanten Spannung und einer im Wesentlichen konstanten Ladung zwischen den Anschlüssen (42, 44) des/der piezoelektrischen Elements/e (4, 4').

6. Wandler nach einem der Ansprüche 1 bis 5, ferner aufweisend eine Schaltung (7) zur Ein-Aus-Steuerung aller oder eines Teils der Schalter (K1, K2, K3, K4, K5, K6, K7, K8).

7. Wandler nach Anspruch 6, wobei die Schaltung (7) in der Lage ist zum Detektieren wenigstens einen der Zeitpunkte des Nulldurchgangs des Bewegungsstroms (i) des (der) piezoelektrischen Elements (Elemente) (4, 4') und zum Erzeugen eines Signals zum Steuern wenigstens eines der Schalter (K1, K2, K3, K4, K5, K6, K7, K8) in Abhängigkeit vom detektierten Nulldurchgangszeitpunkt.

8. Wandler nach Anspruch 7, wobei das Detektieren des Nulldurchgangs des Stroms erfolgt durch eine Messung und einen Vergleich mit Null des durch das/die piezoelektrische(n) Element(e) (4, 4') fließenden Stroms während einer Phase mit konstanter Spannung (III), oder durch eine Messung und einen Vergleich mit Null der Ableitung der Spannung über dem (den) piezoelektrischen Element(en) (4, 4') während einer Phase mit konstanter Ladung (VI), oder durch eine Messung der Verformung des (der) piezoelektrischen Elements (Elemente) (4, 4') und das Ableiten des Zeitpunkts des Grenzübergangs der Verformung.

9. Wandler nach einem der Ansprüche 1 bis 8, wobei der Wandler konfiguriert ist zum zyklischen Steuern der Schalter (K1, K2, K3, K4, K5, K6, K7, K8) mit einer annähernd konstanten, vorzugsweise konstanten, Frequenz, wobei der Wechsel der Phasen bei einer im Wesentlichen konstanten Spannung und bei einer im Wesentlichen konstanten Ladung über dem/den piezoelektrischen Element(en) (4, 4') für jede Resonanzperiode des piezoelektrischen Elements angelegt wird.

10. Wandler nach einem der Ansprüche 1 bis 9, wobei die Summe der von dem/den piezoelektrischen Element(en) (4, 4') über eine Resonanzperiode ausgetauschten Ladungen im Wesentlichen Null ist.

## Claims

1. Power converter comprising:
a first branch and a second branch of at least two series-connected switches (K1, K7; K5, K6) each, coupled in parallel between a first terminal (42) and a second terminal (29') and having their midpoints coupled to two terminals (22, 24) of application of a first voltage (Ve);
a third branch and a fourth branch of at least two series-connected switches (K3, K2; K4, K8) each, coupled in parallel between a third terminal (44) and a fourth terminal (29), and having their midpoints coupled to two terminals (26, 28) for supplying a second voltage (Vs); and
at least one first piezoelectric element (4) coupling the first terminal (42) to the third terminal (44),
wherein:
at least one first switch (K1) couples the first terminal (42) to a terminal (22) of application of the first voltage (Ve);
at least one second switch (K2) couples a terminal (26) for supplying the second voltage (Vs) to the fourth terminal (29) ;
at least one third switch (K3) couples the third terminal (44) to said terminal (26) for supplying the second voltage (Vs);
at least one fourth switch (K4) couples the third terminal (44) to the other terminal (28) for supplying the second voltage (Vs);
at least one fifth switch (K5) couples the first terminal (42) to the other terminal (24) of application of the first voltage (Ve);
at least one sixth switch (K6) couples said other terminal (24) of application of the first voltage to the second terminal (29');
at least one seventh switch (K7) couples said terminal (22) of application of the first voltage to the second terminal (29'); and
at least one eighth switch (K8) couples said other terminal (28) for supplying the second voltage to the fourth terminal (29);
wherein the second (29') and fourth (29) terminals are interconnected;
and wherein the turning on of each switch (K1, K2, K3, K4, K5, K6, K7, K8) is performed under an approximately zero voltage thereacross, the control of the switches (K1, K2, K3, K4, K5, K6, K7, K8) being synchronized with respect to the current internal to the piezoelectric element, so that:
a power transfer from the first voltage to the piezoelectric element occurs at least when, at the same time, the first and sixth switches are on, and either the fourth and eighth switches or the second and third switches are on, the other switches being off; and
a power transfer from the piezoelectric element to the second voltage occurs at least when, at the same time, the second and fourth switches are on, and either the first and seventh switches or the fifth and sixth switches are on, the other switches being off.

2. Converter according to claim 1, wherein the second (29') and fourth (29) terminals are directly interconnected.

3. Converter according to claim 1, wherein at least one capacitive element couples the second terminal (29') to the fourth terminal (29).

4. Converter according to claim 1, wherein at least one second piezoelectric element (4') couples the second terminal (29') to the fourth terminal (29).

5. Converter according to any of claims 1 to 4, wherein the power converter is configured to control the switches (K1, K2, K3, K4, K5, K6, K7, K8) to alternate phases at a substantially constant voltage and at a substantially constant charge between the terminals (42, 44) of the piezoelectric element(s) (4, 4').

6. Converter according to any of claims 1 to 5, further comprising a circuit (7) for controlling, on or off, all or part of the switches (K1, K2, K3, K4, K5, K6, K7, K8).

7. Converter according to claim 6, wherein said circuit (7) is capable of detecting at least one of the times of zero crossing of the motional current (i) of the piezoelectric element(s) (4, 4'), and of generating a signal for controlling at least one of the switches (K1, K2, K3, K4, K5, K6, K7, K8) according to the detected zero crossing time.

8. Converter according to claim 7, wherein the detection of the zero crossing of the current is performed by a measurement and a comparison with zero of the current flowing through the piezoelectric element(s) (4, 4') during a phase at constant voltage (III), or by a measurement and a comparison with zero of the derivative of the voltage across the piezoelectric element(s) (4, 4') during a phase at constant charge (VI), or by a measurement of the deformation of the piezoelectric element(s) (4, 4') and a deduction of the deformation limit crossing time.

9. Converter according to any of claims 1 to 8, wherein the converter is configured to cyclically control the switches (K1, K2, K3, K4, K5, K6, K7, K8) at an approximately constant, preferably constant, frequency, the alternation of the phases at a substantially constant voltage and at a substantially constant charge across the piezoelectric element(s) (4, 4') being applied for each resonance period of the piezoelectric element.

10. Converter according to any of claims 1 to 9, wherein the sum of the charges exchanged by the piezoelectric element(s) (4, 4') over a resonance period is substantially zero.
